# EUROPEAN PATENT APPLICATION

(11) **EP 4 703 791 A2**
(43) Date of publication of application: **04.03.2026**
(21) Application number: 25196278.3
(22) Date of filing: 15.08.2025
(51) Int. Cl.: G03F 1/26, G03F 1/54

(54) **PHASE SHIFT MASK BLANK AND METHOD FOR MANUFACTURING PHASE SHIFT MASK**

(30) Priority: 03.09.2024 JP 2024151206
(71) Applicant: SHIN-ETSU CHEMICAL CO., LTD.,, Chiyoda-ku, Tokyo 1000005 (JP)
(72) Inventor: MIYAJIMA, Chiaki, Joetsu-shi, 9428601 (JP)
(74) Representative: Mewburn Ellis LLP

(57) **Abstract**

A phase shift mask blank includes a phase shift film and a light shielding film formed in contact with the phase shift film and formed of a material containing chromium, wherein the phase shift film is formed of a material containing silicon and free of carbon, the light shielding film is formed of a material containing chromium, oxygen, nitrogen, and carbon, the light shielding film has a laminated structure including four layers: a first layer, a second layer, a third layer, and a fourth layer, the first layer being a layer farthest from the transparent substrate, and the fourth layer being a layer in contact with the phase shift film, and the second layer is a layer containing carbon, and the fourth layer contacting the phase shift film is a layer free of carbon.

## Description

### TECHNICAL FIELD

The present invention relates to a phase shift mask blank to be a material of a phase shift mask for use in manufacturing a semiconductor device or the like, and a method for manufacturing a phase shift mask using the phase shift mask blank.

### BACKGROUND

In recent years, with miniaturization of semiconductor devices, particularly with high integration of large-scale integrated circuits, high pattern resolution is required for projection exposure. Therefore, for photomasks, a phase shift method has been developed as a method for improving the resolution of transfer patterns. The principle of the phase shift method is that a phase of a transmitted being having passed through an opening of a mask pattern (phase shift film pattern) is adjusted to be inverted by about 180 degrees with respect to a phase of a transmitted being having passed through a portion adjacent to the opening, whereby the light intensity is weakened at a boundary portion between the transmitted beams when the transmitted beams interfere with each other, and as a result, the resolution and the focal depth of the transfer pattern are improved, and a photomask using this principle is called a phase shift mask.

The most common structure for a phase shift mask blank used as a material for a phase shift mask is that a phase shift film is laminated on a transparent substrate such as a glass substrate, and a film containing chromium (Cr) is laminated on the phase shift film. The phase shift film usually has a phase difference of about 175 to 185 degrees and a transmittance of about 6 to 30% with respect to exposure light used in a wafer exposure device, and is typically formed of a film containing molybdenum (Mo) and silicon (Si). In addition, the thickness of the film containing chromium (Cr) is adjusted to a desired optical density (OD) when combined with the phase shift film, and the film containing chromium (Cr) is generally used as a light shielding film and a hard mask for etching the phase shift film.

As a method for manufacturing a phase shift mask by forming a phase shift film pattern from a phase shift mask blank, specifically, first, a resist film is formed on the film containing chromium (Cr) of the phase shift mask blank, a pattern is drawn on the resist film by light or an electron beam and developed to form a resist pattern, and the film containing chromium (Cr) is etched, using the resist pattern as an etching mask, to form a pattern of the film containing chromium (Cr). Next, the phase shift film is etched, using the pattern of the film containing chromium (Cr) as an etching mask, to form a phase shift film pattern. Next, the resist pattern is removed with an aqueous solution containing sulfuric acid, for example, a sulfuric acid/hydrogen peroxide solution (a mixed solution of sulfuric acid and hydrogen peroxide). Furthermore, the surface of the film is cleaned with an aqueous solution containing a basic substance such as ammonia (NH₃) to neutralize the surface of the film, and then the pattern of the film containing chromium (Cr) is removed by etching.

When the pattern of the film containing chromium (Cr) is removed, in general, the light shielding film is left outside the region where the circuit pattern is formed of the phase shift film pattern, and the left light shielding film serves as a light shielding portion (light shielding film pattern) at an outer peripheral edge portion of the phase shift mask in such a manner that a total optical density (OD) of the phase shift film and the light shielding film is usually 3 or more. This is to prevent unnecessary exposure light from leaking and irradiating the resist film on an adjacent chip located outside the circuit pattern when the circuit pattern is transferred to the wafer using the wafer exposure device. As a method of forming such a light shielding portion, it is general that a phase shift film pattern is formed, a resist pattern is removed, and then a resist film is newly formed. Using a resist pattern formed by drawing and developing a pattern as an etching mask, the film containing chromium (Cr) is etched in a circuit pattern portion of the phase shift film pattern so that the light shielding portion is left at the outer peripheral edge portion.

For a phase shift mask, which requires high-precision pattern formation, dry etching using gas plasma is mainly used as etching. Dry etching using a chlorine (Cl)-based gas containing oxygen (O) (chlorine (Cl)-based dry etching) is used for dry-etching a film containing chromium (Cr), and dry etching using a fluorine (F)-based gas (fluorine (F)-based dry etching) is used for dry-etching a film containing molybdenum (Mo) and silicon (Si). In particular, it is known that, in dry-etching a film containing chromium (Cr), the chemical reactivity is enhanced and the etching rate is improved by using an etching gas obtained by mixing 10 to 25 vol% of an oxygen gas (O₂ gas) with the chlorine (Cl)-based gas.

As circuit patterns become finer, a technique for forming fine phase shift film patterns is also required for phase shift masks. In particular, a line pattern of an assist pattern that assists the resolution of the main pattern of the phase shift mask needs to be formed smaller than the main pattern so as not to be transferred to a wafer when the circuit pattern is transferred to the wafer using a wafer exposure device. In a phase shift mask of a generation in which a line and space pattern of a main pattern has a pitch of 10 nm in the circuit pattern on the wafer, a line and space pattern of an assist pattern on the phase shift mask is required to have a line width of about 40 nm.

On the other hand, a chemically amplified resist used for forming a photomask pattern such as a phase shift film pattern includes a base resin, an acid generator, a surfactant, etc., and can be used in many reactions in which an acid generated by exposure acts as a catalyst, making it possible to achieve high sensitivity. The chemically amplified resist makes it possible to form a mask pattern such as a fine phase shift film pattern having a line width of 200 nm or less. However, even in the chemically amplified resist, if a pattern width is narrow, a fine line pattern collapses due to a collision of a developer in a development process, and the resolution limit is reached.

Regarding the thinning of the resist film, for example, in the method described in WO 2010/038445 (Patent Document 1), in order to form a fine pattern, a film containing molybdenum (Mo) and silicon (Si), which can be made thin, is formed as a film for forming a mask pattern, and an etching mask film is formed thereon, the etching mask film being a film containing chromium and carbon such as a film made of chromium oxycarbide nitride, which has a high etching rate, thereby thinning the resist film and reducing a collapse of a resist pattern.

In etching using a resist film (resist pattern), the resist pattern is also etched to some extent during the etching, and if the resist pattern disappears, defects such as pinholes occur in the film below the resist pattern (on the transparent substrate side). Therefore, the thickness of the resist film needs to be set such that the resist pattern remains at a predetermined thickness after the etching. In the method described in WO 2010/038445 (Patent Document 1), the film for forming the mask pattern is a film containing molybdenum (Mo), and the etching mask film is a film containing chromium and carbon, which has a relatively high etching rate and can be made thin, so that the time for etching the film containing chromium is shortened, the resist film is thinned, and the line edge roughness (LER) is further reduced.

### Citation List

| | |
|---|---|
| Patent Document 1: | WO 2010/038445 |
| Patent Document 2: | JP-A 2008-51880 |

### SUMMARY OF THE INVENTION

For a photomask used in a process of manufacturing an advanced semiconductor device, a protection member called a pellicle is used to prevent a failure in pattern transfer caused by adhesion of foreign matter. The pellicle includes a transparent film that transmits exposure light and a frame for attaching the transparent film. By attaching the pellicle to the photomask, it is possible to prevent a foreign matter from adhering to the surface of the photomask. However, even in the photomask to which the pellicle is attached, there is a problem that a foreign matter (grown foreign matter) called a haze is generated on the surface of the photomask due to accumulation of the irradiation amount of exposure light, resulting in a failure in pattern transfer. In the process of manufacturing the advanced semiconductor device, as the circuit pattern is fine, the exposure light used has currently shifted from KrF excimer laser having a wavelength of 248 nm to ArF excimer laser having a shorter wavelength of 193 nm. However, the higher the energy (the shorter the wavelength of the exposure light), the more noticeable the occurrence of haze.

If a haze occurs on a photomask, a desired pattern cannot be formed on a wafer with the photomask on which the haze has occurred, because the haze becomes an obstacle (defect) to the exposure light. If a haze has occurred, it is necessary to remove the pellicle once and clean the photomask to remove the haze. Furthermore, it is also necessary to confirm that the haze is completely removed after the cleaning using a photomask pattern inspection device, and the generation of the haze greatly reduces the productivity in the process of manufacturing the semiconductor device.

In particular, in the manufacture of memory-based devices, a single photomask is used for exposure of 100,000 or more wafers. Therefore, the photomask used in the manufacture of memory-based devices has a larger cumulative amount of irradiation of exposure light than a photomask used in the manufacture of logic-based devices. In wafer exposure for manufacturing semiconductor devices, a light amount of exposure light irradiated in one-time exposure is 10 to 20 mJ/cm² in a case where the exposure light is ArF excimer laser. Meanwhile, a circuit pattern of a photomask is exposed to a single wafer multiple times. Therefore, if a single photomask is used for exposure of 100,000 or more wafers, a cumulative amount of irradiation of exposure light to the photomask is several tens of kJ/cm².

It is considered that one of the causes of the haze is that sulfate ions (SO₄²⁻), which are acidic substances contained in an aqueous solution containing sulfuric acid used for cleaning to peel off the resist pattern in a process of manufacturing the photomask, remain on the surface of the film, and furthermore, basic ions contained in an aqueous solution containing a basic substance such as ammonia (NH₃) used to neutralize the surface of the film thereafter (e.g., ammonium ions (NH₄⁺) in a case where the basic substance is ammonia (NH₃)) remain on the surface of the film, the sulfate ions and the basic ions react with each other when irradiated with exposure light, forming a salt (e.g., ammonium sulfate ((NH₄)₂SO₄)), and further, the salt grows into a solid (granular) by accumulation of the irradiation amount of the exposure light (see, for example, JP-A 2008-51880 (Patent Document 2)).

The present invention has been made to solve the aforementioned problems, and an object thereof is to provide a phase shift mask blank capable of thinning a resist film, and providing a phase shift mask in which a haze, which occurs when an irradiation amount of exposure light is accumulated, is suppressed, and to provide a method for manufacturing a phase shift mask from such a phase shift mask blank.

In a case where a circuit pattern is formed on a phase shift film, which is a film for forming the circuit pattern, and a film containing chromium (Cr) is formed in contact with the circuit pattern (phase shift film pattern), even if the film containing chromium (Cr) is removed from above the phase shift film pattern by dry etching using a chlorine (Cl)-based gas containing oxygen (O), chromium (Cr) may remain on the surface of the phase shift film pattern. If chromium (Cr) remains on the surface of the phase shift film pattern, the chromium (Cr) reacts when irradiated with exposure light, and becomes a chromium (Cr) compound such as chromium oxide (CrO). The chromium (Cr) compound such as chromium oxide (CrO) further grows into a solid (granular), causing a haze.

In particular, in a case where the phase shift film contains a transition metal such as molybdenum (Mo), and the film containing chromium (Cr) contains carbon (C), the transition metal such as molybdenum (Mo) and carbon (C) react with each other at an interface between the two films, forming a transition metal carbide such as molybdenum carbide (MoC). The transition metal carbide having a high melting point and a high hardness is difficult to etch by dry etching using a chlorine (Cl)-based gas containing oxygen (O), and is also difficult to remove by cleaning.

In particular, molybdenum carbide (MoC) is hardly etched by dry etching using a chlorine (Cl)-based gas containing oxygen (O), and thus is difficult to completely remove. As a result, after the phase shift film pattern is formed, the transition metal carbide such as molybdenum carbide (MoC) remains on the phase shift film pattern with chromium (Cr) incorporated therein, and a chromium (Cr) compound such as chromium oxide (CrO) derived from chromium (Cr) causes a noticeable haze. In this case, the chromium (Cr) compound such as chromium oxide (CrO) spreads not only on the phase shift film pattern (line pattern) but also to a space pattern (a portion where the circuit pattern does not exist, for example, on the transparent substrate) adjacent to the phase shift film pattern due to the accumulation of the irradiation amount of the exposure light, causing a haze on the space pattern as well.

On the other hand, in a case where the phase shift film contains silicon (Si), and the film containing chromium (Cr) contains carbon (C), silicon (Si) and carbon (C) react with each other at an interface between the two films, forming silicon carbide (SiC). In this case, when a phase shift film pattern is formed, and the film containing chromium (Cr) is removed from above the phase shift film pattern by dry etching using a chlorine (Cl)-based gas containing oxygen (O) in a process of manufacturing a phase shift mask, silicon carbide (SiC) is hardly etched by dry etching using a chlorine (Cl)-based gas containing oxygen (O), and thus silicon carbide (SiC) remains on a surface portion of the phase shift film pattern. Since silicon carbide (SiC) is easily dissolved in an aqueous solution containing sulfuric acid, when the aqueous solution containing sulfuric acid, which is used for removing the resist film used to form a light shielding portion (light shielding film pattern) at the outer peripheral edge portion of the phase shift film and for cleaning the phase shift mask in the process of manufacturing the phase shift mask from the phase shift mask blank, comes into contact with silicon carbide (SiC) remaining on the surface portion of the phase shift film pattern, silicon carbide (SiC) is dissolved and removed, optical characteristics (phase difference, transmittance, etc.) of the phase shift film pattern change.

As a result of intensive studies to solve the aforementioned problems, the present inventors have arrived at the present invention, finding that a phase shift mask blank is capable of thinning a resist film to be used in manufacturing a phase shift mask, if the phase shift mask blank includes a phase shift film and a light shielding film formed in contact with the phase shift film and formed of a material containing chromium (Cr), wherein the phase shift film is formed of a material containing silicon (Si) and free of carbon (C), the light shielding film is formed of a material containing chromium (Cr), oxygen (O), nitrogen (N), and carbon (C), the light shielding film has a laminated structure including four layers: a first layer, a second layer, a third layer, and a fourth layer, or four layers: a first layer, a third layer, a second layer, and a fourth layer, in this order from a side away from a transparent substrate, the first layer being a layer farthest from the transparent substrate, and the fourth layer being a layer in contact with the phase shift film, and the second layer is a layer containing carbon (C) and the fourth layer is a layer free of carbon (C) in the laminated structure, and a phase shift mask obtained from the phase shift mask blank is a phase shift mask in which a haze hardly occurs and optical characteristics of the phase shift film hardly change even when the phase shift film is cleaned with an aqueous solution containing sulfuric acid.

Therefore, the present invention provides a phase shift mask blank and a method for manufacturing a phase shift mask as follows.
1. A phase shift mask blank including:
   a transparent substrate;
   a phase shift film provided on the transparent substrate, and formed of a material containing silicon (Si) and free of carbon (C); and
   a light shielding film provided on a side of the phase shift film away from the transparent substrate, and formed of a material containing chromium (Cr), oxygen (O), nitrogen (N), and carbon (C),
   wherein the light shielding film has a laminated structure including four layers: a first layer, a second layer, a third layer, and a fourth layer, or four layers: a first layer, a third layer, a second layer, and a fourth layer, in this order from the side away from the transparent substrate,
   in the laminated structure, the first layer is a layer farthest from the transparent substrate, and the fourth layer is a layer in contact with the phase shift film,
   the first layer contains chromium (Cr) and oxygen (O), with a chromium (Cr) content being 28 atom% or more and 40 atom% or less, and an oxygen (O) content being 47 atom% or more and 60 atom% or less, and the first layer has a thickness of 1 nm or more and 4 nm or less,
   the second layer contains chromium (Cr), oxygen (O), nitrogen (N), and carbon (C), with a chromium (Cr) content being 30 atom% or more and 45 atom% or less, an oxygen (O) content being 28 atom% or more and 40 atom% or less, a nitrogen (N) content being 12 atom% or more and 24 atom% or less, and a carbon (C) content being 5 atom% or more and 15 atom% or less, and the second layer has a thickness of 18 nm or more and 24 nm or less,
   the third layer contains chromium (Cr) and nitrogen (N), with a chromium (Cr) content being 50 atom% or more and 60 atom% or less, and a nitrogen (N) content being 20 atom% or more and 40 atom% or less, and the third layer has a thickness of 1 nm or more and 6 nm or less, and
   the fourth layer contains chromium (Cr), oxygen (O), and nitrogen (N), and is free of carbon (C), with a chromium (Cr) content being 35 atom% or more and 44 atom% or less, an oxygen (O) content being 42 atom% or more and 54 atom% or less, and a nitrogen (N) content being 2 atom% or more and 20 atom% or less, and the fourth layer has a thickness of 18 nm or more and 36 nm or less.
2. The phase shift mask blank according to 1, wherein the phase shift film has a zeta potential of -15 mV or more and +15 mV or less at a pH of 3 or more and 4 or less, and a zeta potential of -60 mV or more and +10 mV or less at a pH of 5 or more and 6 or less.
3. The phase shift mask blank according to 1, wherein
   the first layer contains nitrogen (N), with a nitrogen (N) content being 5 atom% or more and 25 atom% or less, and
   the third layer contains oxygen (O), with an oxygen (O) content being 6 atom% or more and 30 atom% or less.
4. The phase shift mask blank according to 1, wherein the material forming the phase shift film contains nitrogen (N).
5. The phase shift mask blank according to 1, wherein the material forming the phase shift film is free of a transition metal.
6. The phase shift mask blank according to 1, wherein a total sheet resistance of the first layer, the second layer, the third layer, and the fourth layer of the light shielding film is 350 kΩ/□ or less.
7. The phase shift mask blank according to 1, wherein the phase shift film has a phase difference of 175 degrees or more and 185 degrees or less and a transmittance of 6% or more and 30% or less with respect to exposure light that is ArF excimer laser (having a wavelength of 193 nm), and the phase shift film has a thickness of 60 nm or more and 85 nm or less.
8. The phase shift mask blank according to 1, wherein a total optical density (OD) of the phase shift film and the light shielding film with respect to exposure light that is ArF excimer laser (having a wavelength of 193 nm) is 3 or more.
9. The phase shift mask blank according to 8, wherein the light shielding film has a thickness of 48 nm or more and 54 nm or less.
10. A method for manufacturing a phase shift mask having a circuit pattern of the phase shift film from the phase shift mask blank according to any one of 1 to 9, the method including:
   (A) forming a first resist film on the light shielding film;
   (B) forming a first resist pattern by patterning the first resist film;
   (C) forming a light shielding film pattern by patterning the light shielding film by dry etching using a chlorine (Cl)-based gas containing oxygen (O), using the first resist pattern as an etching mask;
   (D) forming a phase shift film pattern by patterning the phase shift film by dry etching using a fluorine (F)-based gas, using the light shielding film pattern as an etching mask;
   (E) removing the first resist pattern;
   (F) forming a second resist film on the light shielding film pattern;
   (G) forming a second resist pattern on an outer peripheral edge portion located outside a region where the circuit pattern of the phase shift film is formed by patterning the second resist film;
   (H) removing the light shielding film pattern in the region where the circuit pattern of the phase shift film is formed by dry etching using a chlorine (Cl)-based gas containing oxygen (O), using the second resist pattern as an etching mask; and
   (I) removing the second resist pattern.

### ADVANTAGEOUS EFFECTS

According to the phase shift mask blank of the present invention, it is possible to thin a resist film to be used in manufacturing a phase shift mask, and it is possible to provide a phase shift mask in which a haze hardly occurs, and optical characteristics of a phase shift film hardly change even when the phase shift film is cleaned with an aqueous solution containing sulfuric acid.

### BRIEF DESCRIPTION OF THE DRAWINGS

FIG. 1 is a cross-sectional view illustrating an example of a phase shift mask blank of the present invention;
FIG. 2 is a cross-sectional view illustrating an example of a phase shift mask of the present invention;
FIG. 3 is a cross-sectional view illustrating another example of a phase shift mask blank of the present invention; and
FIG. 4 is a cross-sectional view illustrating another example of a phase shift mask of the present invention.

### FURTHER EXPLANATIONS; OPTIONS AND PREFERENCES

Hereinafter, the present invention is described in more detail.

A phase shift mask blank of the present invention includes a transparent substrate, a phase shift film provided on the transparent substrate, and a light shielding film provided in contact with the phase shift film on a side of the phase shift film away from the transparent substrate. The light shielding film has a laminated structure including four layers: a first layer, a second layer, a third layer, and a fourth layer, or four layers: a first layer, a third layer, a second layer, and a fourth layer in this order from the side away from the transparent substrate.

From the phase shift mask blank of the present invention, a phase shift mask having a circuit pattern of a phase shift film (phase shift film pattern) on the transparent substrate can be manufactured. In particular, the phase shift mask blank of the present invention is suitable for manufacturing a phase shift mask having a light shielding portion (light shielding film pattern) at an outer peripheral edge portion of the phase shift mask, the light shielding portion being formed from the light shielding film in contact with the phase shift film outside a region where the circuit pattern of the phase shift film is formed (effective region).

The phase shift mask blank and the phase shift mask manufactured from the phase shift mask blank of the present invention are suitable as a phase shift mask blank and a phase shift mask using light having a wavelength of 200 nm or less, such as ArF excimer laser (having a wavelength of 193 nm), as exposure light.

Hereinafter, the phase shift mask blank and the phase shift mask of the present invention are described with reference to the drawings, but the same components are denoted by the same reference signs, and the description thereof may be omitted. In addition, the drawings may be shown in an exaggerated manner for convenience, and a dimensional ratio and the like between the components is not necessarily the same as actual one.

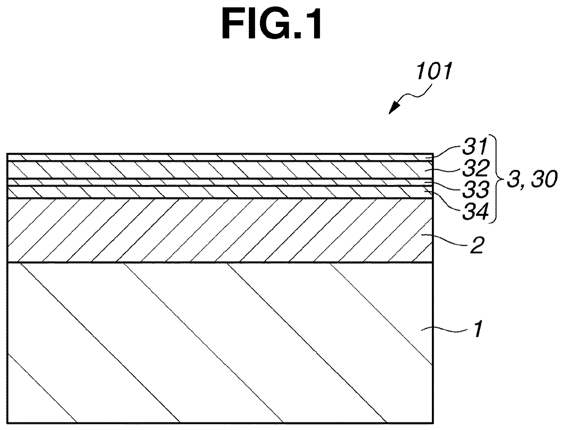

FIG. 1 is a cross-sectional view illustrating an example of a phase shift mask blank of the present invention. A phase shift mask blank 101 includes a transparent substrate 1, a phase shift film 2 provided on the transparent substrate 1, and a light shielding film 3 provided in contact with the phase shift film 2 on a side of the phase shift film 2 away from the transparent substrate 1. The light shielding film 3 has a laminated structure 30 including four layers: a first layer 31, a second layer 32, a third layer 33, and a fourth layer 34 in this order from the side away from the transparent substrate 1.

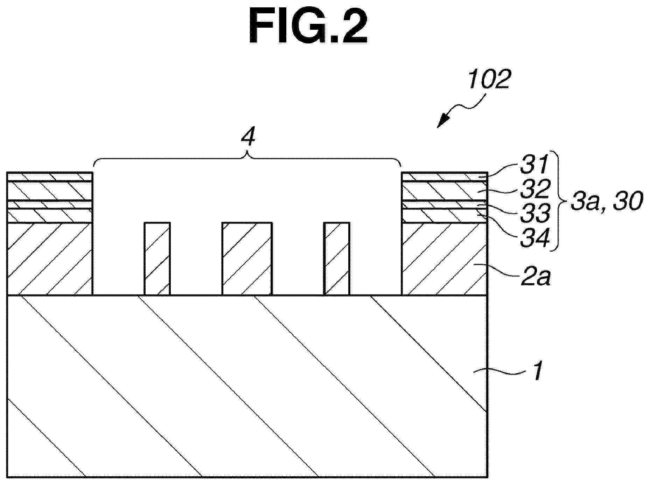

A phase shift mask illustrated in FIG. 2 can be manufactured from the phase shift mask blank illustrated in FIG. 1. FIG. 2 is a cross-sectional view illustrating an example of a phase shift mask of the present invention. A phase shift mask 102 includes a transparent substrate 1, a phase shift film pattern 2a provided on the transparent substrate 1, and a light shielding film pattern 3a provided in contact with the phase shift film pattern 2a in a portion located at an outer peripheral edge portion of a main surface of the transparent substrate on a side of the phase shift film pattern 2a away from the transparent substrate 1, with a circuit pattern formed in an effective region 4. The light shielding film pattern 3a has a laminated structure 30 including four layers: a first layer 31, a second layer 32, a third layer 33, and a fourth layer 34 in this order from the side away from the transparent substrate 1.

In FIGS. 1 and 2, the first layer 31 is a layer that is in contact with the second layer 32 and is farthest from the transparent substrate 1. The second layer 32 is a layer that is in contact with the first layer 31 and the third layer 33. The third layer 33 is a layer that is in contact with the second layer 32 and the fourth layer 34. The fourth layer 34 is a layer that is in contact with the third layer 33 and the phase shift film 2.

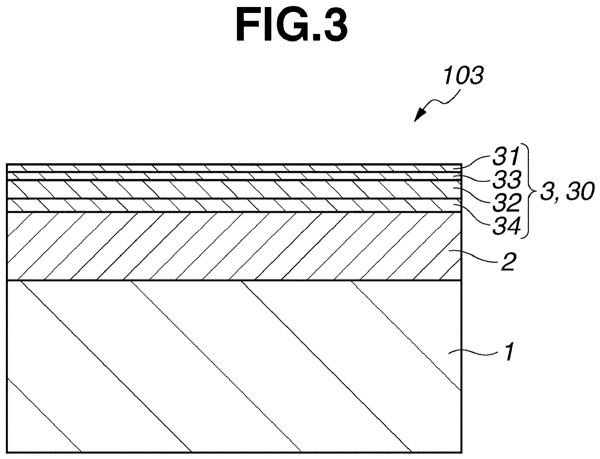

FIG. 3 is a cross-sectional view illustrating another example of a phase shift mask blank of the present invention. A phase shift mask blank 103 includes a transparent substrate 1, a phase shift film 2 provided on the transparent substrate 1, and a light shielding film 3 provided in contact with the phase shift film 2 on a side of the phase shift film 2 away from the transparent substrate 1. The light shielding film 3 has a laminated structure 30 including four layers: a first layer 31, a third layer 33, a second layer 32, and a fourth layer 34 in this order from the side away from the transparent substrate 1.

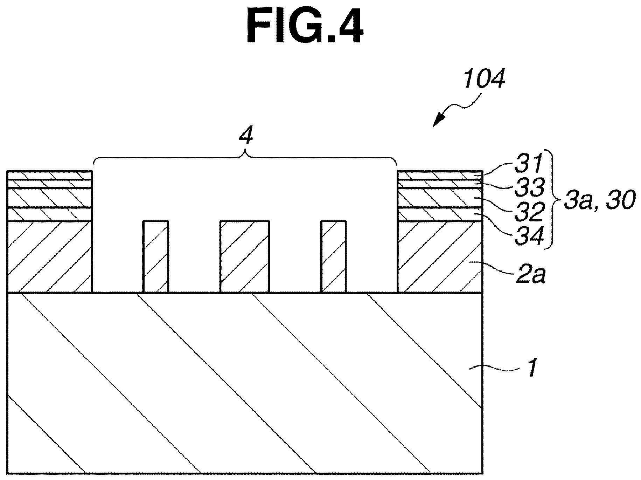

A phase shift mask illustrated in FIG. 4 can be manufactured from the phase shift mask blank illustrated in FIG. 3. FIG. 4 is a cross-sectional view illustrating another example of a phase shift mask of the present invention. A phase shift mask 104 includes a transparent substrate 1, a phase shift film pattern 2a provided on the transparent substrate 1, and a light shielding film pattern 3a provided in contact with the phase shift film pattern 2a in a portion located at an outer peripheral edge portion of a main surface of the transparent substrate on a side of the phase shift film pattern 2a away from the transparent substrate 1, with a circuit pattern formed in an effective region 4. The light shielding film pattern 3a has a laminated structure 30 including four layers: a first layer 31, a third layer 33, a second layer 32, and a fourth layer 34 in this order from the side away from the transparent substrate 1.

In FIGS. 3 and 4, the first layer 31 is a layer that is in contact with the third layer 33 and is farthest from the transparent substrate 1. The third layer 33 is a layer that is in contact with the first layer 31 and the second layer 32. The second layer 32 is a layer that is in contact with the third layer 33 and the fourth layer 34. The fourth layer 34 is a layer that is in contact with the second layer 32 and the phase shift film 2.

The type and size of the transparent substrate are not particularly limited as long as the substrate is transparent at a wavelength used as an exposure wavelength, and for example, a quartz substrate such as a synthetic quartz substrate is used. As the transparent substrate, for example, a substrate called a 6025 substrate having a size of 6 inches square and 0.25 inches thick as defined by the SEMI standard is suitable. When the SI unit system is used, the size of the 6025 substrate is usually described as 152 mm square and 6.35 mm thick.

In the present invention, the phase shift film may be formed in contact with the transparent substrate, or may be formed on the transparent substrate via one or more other films. The phase shift film may be a single-layer film, a multi-layer film (e.g., a film including two, three, or four layers), or a film having a gradient composition.

The phase shift film is preferably a halftone phase shift film. In a case where the phase shift film is a halftone phase shift film, the phase shift mask blank is a halftone phase shift mask blank, and the phase shift mask is a halftone phase shift mask.

The phase shift film is formed of a material containing silicon (Si) and free of carbon (C). The material containing silicon (Si) and free of carbon (C) preferably contains one or both of oxygen (O) and nitrogen (N), particularly nitrogen (N). The material containing silicon (Si) and free of carbon (C) of the phase shift film may contain hydrogen (H).

The material containing silicon (Si) and free of carbon (C) of the phase shift film may be a silicon (Si) compound containing silicon (Si) and one or both of oxygen (O) and nitrogen (N). Specific examples of the silicon (Si) compound include a material composed of silicon (Si) and nitrogen (N) (silicon nitride (SiN)), and a material composed of silicon (Si), oxygen (O), and nitrogen (N) (silicon oxynitride (SiON)).

The material containing silicon (Si) and free of carbon (C) is preferably free of chromium (Cr). The material containing silicon (Si) and free of carbon (C) may contain a transition metal other than chromium (Cr). In a case where the material contains a transition metal other than chromium (Cr), the content of the transition metal other than chromium (Cr) is preferably 6 atom% or less, and more preferably 4 atom% or less on average throughout.

In addition, the material containing silicon (Si) and free of carbon (C) of the phase shift film in a case where the material contains a transition metal (Me) other than chromium (Cr) may be a transition metal silicon (MeSi) compound containing a transition metal (Me) and silicon (Si), or containing a transition metal (Me), silicon (Si), and one or both of nitrogen (N) and oxygen (O). Specific examples of the transition metal silicon (MeSi) compound include a material composed of a transition metal (Me), silicon (Si), and nitrogen (N) (transition metal silicon nitride (MeSiN)), and a material composed of a transition metal (Me), silicon (Si), oxygen (O), and nitrogen (N) (transition metal silicon oxynitride (MeSiON)).

Examples of the transition metal (Me) other than chromium (Cr) include molybdenum (Mo), tungsten (W), tantalum (Ta), titanium (Ti), zirconium (Zr), and hafnium (Hf).

The material containing silicon (Si) and free of carbon (C) is preferably free of a transition metal. If the material containing silicon (Si) and free of carbon (C), which forms the phase shift film, is free of a transition metal, even if carbon (C) reaches an interface between the phase shift film and the light shielding film from the light shielding film containing carbon (C) together with chromium (Cr), the carbon (C) does not react with a transition metal at the interface between the phase shift film and the light shielding film, not forming a transition metal carbide. Therefore, a transition metal carbide such as molybdenum carbide (MoC) does not remain with chromium (Cr) incorporated therein after the light shielding film is removed from above the phase shift film pattern, thereby suppressing a haze that occurs if a transition metal carbide such as molybdenum carbide (MoC) remains with chromium (Cr) incorporated therein.

The phase shift film is preferably formed of a material that is resistant to dry etching using a chlorine (Cl)-based gas containing oxygen (O) and can be removed by dry etching using a fluorine (F)-based gas.

In the present invention, the dry etching using a chlorine (Cl)-based gas containing oxygen (O) may typically be dry etching using a mixed gas of a chlorine gas (Cl₂ gas) and an oxygen gas (O₂ gas) (e.g., a gas obtained by mixing 10 to 25 vol% of an oxygen gas (O₂ gas) with a chlorine gas (Cl₂ gas)). On the other hand, in the present invention, the dry etching using a fluorine (F)-based gas may typically be dry etching using a gas containing a carbon tetrafluoride gas (CF₄ gas) or a sulfur hexafluoride gas (SF₆ gas).

In the present invention, the phase shift film preferably has a zeta potential within a predetermined range. The zeta potential is an index indicating a degree in which a surface layer of a film is charged (a phenomenon in which electric charges are accumulated). When the zeta potential is zero (0), protons (cations of hydrogen) on the surface layer of the film are equivalent to electric charges in the film, which is an electrically neutral state. On the other hand, when the zeta potential is negative (-), there are fewer protons on the surface layer of the film as compared to electric charges in the film, which is an electrically negative state, and when the zeta potential is positive (+), there are more protons on the surface layer of the film as compared to electric charges in the film, which is an electrically positive state.

In the present invention, the phase shift film preferably has a zeta potential in a predetermined range at a pH of 3 or more and 4 or less. In a phase shift mask manufacturing process, an aqueous solution containing sulfuric acid such as a sulfuric acid/hydrogen peroxide solution (usually having a pH of 4 or less) is usually used in order to peel off a resist pattern. However, when the zeta potential of the phase shift film at the pH of 3 or more and 4 or less is close to an electrically neutral state, sulfate ions (SO₄²⁻) contained in the aqueous solution containing sulfuric acid are less likely to be attracted to the surface of the film, and thus, sulfate ions (SO₄²⁻) are less likely to remain on the surface of the phase shift film. In particular, a phase shift film formed of a material containing silicon (Si) and free of a transition metal is advantageous in that a zeta potential at a pH of 3 or more and 4 or less is close to an electrically neutral state.

Specifically, the zeta potential of the phase shift film at the pH of 3 or more and 4 or less is preferably -15 mV or more and more preferably -10 mV or more, and is preferably +15 mV or less and more preferably +10 mV or less.

In addition, in the present invention, the phase shift film preferably has a zeta potential in a predetermined range at a pH of 5 or more and 6 or less. In a phase shift mask manufacturing process, after using an aqueous solution containing sulfuric acid such as a sulfuric acid/hydrogen peroxide solution to peel off a resist pattern, an aqueous solution containing ammonia (NH₃) (usually having a pH of 5 or more) is usually used to neutralize the surface of the film. However, when the zeta potential of the phase shift film at the pH of 5 or more and 6 or less is close to an electrically weak negative-to-neutral state, ammonium (NH₄⁺) contained in the aqueous solution containing ammonia (NH₃) is less likely to adhere to the surface of the film, and thus ammonium (NH₄⁺) is less likely to remain on the surface of the phase shift film. In particular, a phase shift film formed of a material containing silicon (Si) and free of a transition metal is advantageous in that a zeta potential at a pH of 5 or more and 6 or less is close to an electrically weak negative-to-neutral state.

Specifically, the zeta potential of the phase shift film at the pH of 5 or more and 6 or less is preferably -60 mV or more and more preferably -30 mV or more, and is preferably +10 mV or less and more preferably +5 mV or less. As the zeta potential at the pH of 5 or more and 6 or less is higher (as the zeta potential is closer to the positive (+) side), ammonium (NH₄⁺) repels the surface of the film, making it difficult to attract ammonium (NH₄⁺) to the surface of the film. However, if ammonium (NH₄⁺) is not attracted to the surface of the film, ammonium (NH₄⁺) does not react with sulfate ions (SO₄²⁻), making it difficult to neutralize the surface of the film. Therefore, it is effective to set the upper limit of the zeta potential at the pH of 5 or more and 6 or less as described above.

By setting the zeta potential of the phase shift film at the pH of 3 or more and 4 or less and the zeta potential of the phase shift film at the pH of 5 or more and 6 or less within the predetermined ranges, sulfate ions (SO₄²⁻) contained in an aqueous solution containing sulfuric acid and ammonium (NH₄⁺) contained in an aqueous solution containing ammonia (NH₃) are less likely to remain on the surface of the phase shift film. As a result, reaction between sulfate ions (SO₄²⁻) and ammonium (NH₄⁺) when irradiated with exposure light to form a salt (ammonium sulfate ((NH₄)₂SO₄)) is suppressed, and furthermore, an occurrence of a haze, in which a salt has grown into a solid (granular) due to accumulated irradiation amount of exposure light, is reduced.

The phase shift film preferably has a phase difference of 175 degrees or more and 185 degrees or less with respect to exposure light (specifically, light having a wavelength of 200 nm or less, such as ArF excimer laser (having a wavelength of 193 nm)). In addition, the phase shift film preferably has a transmittance of 6% or more and 30% or less with respect to the exposure light (specifically, light having a wavelength of 200 nm or less, such as ArF excimer laser (having a wavelength of 193 nm)), which is highly effective in improving the resolution and the focal depth of the transfer pattern according to the phase shift effect corresponding to the exposure condition. From the viewpoint of setting the phase difference and the transmittance within the predetermined ranges, the phase shift film has a thickness of preferably 60 nm or more, more preferably 62 nm or more, and preferably 85 nm or less, more preferably 78 nm or less.

In the present invention, the light shielding film is formed in contact with the phase shift film. The light shielding film may be a film having a gradient composition. The light shielding film has a laminated structure including four layers: a first layer, a second layer, a third layer, and a fourth layer, or four layers: a first layer, a third layer, a second layer, and a fourth layer in this order from the side away from the transparent substrate. The laminated structure may include five or more layers, for example, five layers or six layers, but it is preferable that the laminated structure includes only four layers: a first layer, a second layer, a third layer, and a fourth layer, or four layers: a first layer, a third layer, a second layer, and a fourth layer. In a case where the light shielding film includes five or more layers, a layer other than the first layer, the second layer, the third layer, and the fourth layer is provided at any position between the first layer and the fourth layer in the laminated structure.

Concerning the light shielding film, it is preferable that, in dry etching in which the phase shift film is used as a processed film, a light shielding film pattern formed by patterning the light shielding film can be used as an etching mask when forming a phase shift film pattern from the phase shift film. Therefore, the light shielding film is preferably formed of a material that is resistant to dry etching using a fluorine (F)-based gas and can be removed by dry etching using a chlorine (Cl)-based gas containing oxygen (O).

The light shielding film is formed of a material containing chromium (Cr), oxygen (O), nitrogen (N), and carbon (C) throughout the light shielding film. By forming the light shielding film from a material containing carbon (C), the light shielding film etching rate in dry etching using a chlorine (Cl)-based gas containing oxygen (O) is increased, and the time (clear time) for etching the entire light shielding film can be shortened while securing the light shielding property (optical density (OD)) required throughout the light shielding film, thereby making it possible to thin the resist film used when manufacturing the phase shift mask from the phase shift mask blank. The light shielding film is preferably free of silicon (Si). In addition, the light shielding film is preferably free of a transition metal other than chromium (Cr).

Materials forming the first layer, the second layer, the third layer, and the fourth layer constituting the laminated structure of the light shielding film and materials forming the other layers constituting the laminated structure of the light shielding film contain chromium (Cr) as an essential component, and preferably further contain one or more selected from oxygen (O), nitrogen (N), and carbon (C), particularly one or both of oxygen (O) and nitrogen (N). It is preferable that at least one layer selected from the first layer, the second layer, and the third layer, particularly the second layer, contains carbon (C). On the other hand, the fourth layer is free of carbon (C). In addition, at least one layer selected from the first layer, the second layer, and the fourth layer, particularly one or both of the first layer and the fourth layer, is preferably a layer having a relatively high oxygen (O) content. By configuring the first layer, the second layer, the third layer, and the fourth layer in this manner, it is possible to shorten the time (clear time) for etching the entire light shielding film in dry-etching the light shielding film using a chlorine (Cl)-based gas containing oxygen (O) while securing the light shielding property (optical density (OD)) required throughout the light shielding film. Furthermore, an occurrence of a haze in the phase shift film pattern and a change in optical characteristic of the phase shift film pattern are suppressed by the light shielding film that is a single layer containing chromium (Cr), oxygen (O), nitrogen (N), and carbon (C) throughout the light shielding film.

Specifically, the materials forming the first layer, the second layer, the third layer, and the fourth layer constituting the laminated structure of the light shielding film and the materials forming the other layers constituting the laminated structure of the light shielding film may be a material composed of chromium (Cr) and oxygen (O) (chromium oxide (CrO)), a material composed of chromium (Cr) and nitrogen (N) (chromium nitride (CrN)), a material composed of chromium (Cr) and carbon (C) (chromium carbide (CrC)), a material composed of chromium (Cr), oxygen (O), and nitrogen (N) (chromium oxynitride (CrON)), a material composed of chromium (Cr), oxygen (O), and carbon (C) (chromium oxycarbide (CrOC)), a material composed of chromium (Cr), nitrogen (N), and carbon (C) (chromium nitride carbide (CrNC)), and a material composed of chromium (Cr), oxygen (O), nitrogen (N), and carbon (C) (chromium oxynitride carbide (CrONC)).

Each layer of the light shielding film can be a light shielding layer or an antireflection layer. For example, the first layer is suitable as an antireflection layer, and the second layer, the third layer, and the fourth layer are suitable as light shielding layers.

The first layer is a layer on a side farthest from the transparent substrate in the laminated structure. The first layer is usually a layer that is in contact with a resist film when the resist film is formed in contact with the light shielding film when a phase shift mask is manufactured from a phase shift mask blank, and is also a layer that is in direct contact with a cleaning liquid. Furthermore, the first layer is a layer onto which exposure light is directly incident during exposure using the phase shift mask. Therefore, the first layer is provided as a layer having good adhesion to the resist film, high chemical resistance to the cleaning liquid, and low reflectance to exposure light.

The first layer contains chromium (Cr) and oxygen (O). The first layer preferably contains nitrogen (N). The first layer may contain carbon (C) in a small amount, but is preferably free of carbon (C). Specifically, the material forming the first layer may be a material composed of chromium (Cr) and oxygen (O), a material composed of chromium (Cr), oxygen (O), and nitrogen (N), a material composed of chromium (Cr), oxygen (O), and carbon (C), or a material composed of chromium (Cr), oxygen (O), nitrogen (N), and carbon (C), and the material composed of chromium (Cr), oxygen (O), and nitrogen (N) is preferable.

In the first layer, a chromium (Cr) content is preferably 28 atom% or more, more preferably 30 atom% or more, and is preferably 40 atom% or less, more preferably 38 atom% or less, still more preferably 36 atom% or less. In the first layer, an oxygen (O) content is preferably 47 atom% or more, more preferably 49 atom% or more, and is preferably 60 atom% or less, more preferably 57 atom% or less, still more preferably 55 atom% or less. In a case where the first layer contains nitrogen (N), a nitrogen (N) content is more than 0 atom%, preferably 5 atom% or more, more preferably 10 atom% or more, and preferably 25 atom% or less, more preferably 23 atom% or less. In a case where the first layer contains carbon (C), a carbon (C) content is preferably less than 5 atom%, more preferably 3 atom% or less, and still more preferably 2 atom% or less.

The first layer may have any thickness capable of providing adhesion to the resist film and chemical resistance to the aqueous solution used for cleaning, and reducing the reflectance of the light shielding film with respect to exposure light, and can be formed relatively thin among the first layer, the second layer, the third layer, and the fourth layer. In addition, the thinner the first layer, the more effectively the sheet resistance reducing effect of the third layer to be described below can be obtained, allowing a material having relatively low conductivity (relatively high sheet resistance) as the material of the first layer. The thickness of the first layer is preferably 1 nm or more, and is preferably 4 nm or less, more preferably 3 nm or less.

The fourth layer is a layer that is in contact with the phase shift film in the laminated structure. Therefore, the fourth layer is provided as a layer free of carbon (C). By forming the fourth layer as a layer free of carbon (C), there is no reaction between silicon (Si) and carbon (C) at the interface between the phase shift film containing silicon (Si) and the light shielding film, which occurs in a case where the light shielding film containing chromium (Cr) contains carbon (C), and a silicon carbide (SiC) is not formed. Therefore, silicon carbide (SiC) does not remain after the light shielding film is removed from the phase shift film pattern, and a change in optical characteristic (phase difference, transmittance, etc.) of the phase shift film, which is caused in a case where a silicon carbide (SiC) remains, is suppressed.

In addition, by forming the fourth layer as a layer free of carbon (C), even if the phase shift film is formed of a material containing a transition metal, there is no reaction between the transition metal and carbon (C) at the interface between the phase shift film containing the transition metal and the light shielding film, which occurs in a case where the light shielding film containing chromium (Cr) contains carbon (C), and a transition metal carbide is not formed. Therefore, a transition metal carbide such as molybdenum carbide (MoC) does not remain with chromium (Cr) incorporated therein after the light shielding film is removed from above the phase shift film pattern, thereby suppressing a haze that occurs if a transition metal carbide such as molybdenum carbide (MoC) remains with chromium (Cr) incorporated therein.

The fourth layer contains chromium (Cr), oxygen (O), and nitrogen (N). Specifically, a material composed of chromium (Cr), oxygen (O), and nitrogen (N) is preferable as a material forming the fourth layer.

In the fourth layer, a chromium (Cr) content is preferably 35 atom% or more, more preferably 37 atom% or more, and is preferably 44 atom% or less, more preferably 43 atom% or less. In the fourth layer, an oxygen (O) content is preferably 42 atom% or more, more preferably 45 atom% or more, and is preferably 54 atom% or less, more preferably 50 atom% or less. In the fourth layer, a nitrogen (N) content is preferably 2 atom% or more, more preferably 8 atom% or more, and preferably 20 atom% or less, more preferably 12 atom% or less.

The fourth layer preferably has such a thickness that carbon (C) contained in a layer other than the fourth layer does not reach the phase shift film side. In addition, the fourth layer is preferably formed to be relatively thick among the first layer, the second layer, the third layer, and the fourth layer, from the viewpoint of obtaining the light shielding property (optical density (OD)) required throughout the light shielding film because the fourth layer has a relatively high optical density (OD) per unit thickness. The thickness of the fourth layer is preferably 18 nm or more, more preferably 20 nm or more, and is preferably 36 nm or less, more preferably 34 nm or less.

In order to sufficiently secure a light shielding film etching rate in dry etching using a chlorine (Cl)-based gas containing oxygen (O), it is preferable that the light shielding film contains carbon (C), and a large amount of carbon (C) is contained in the light shielding film. The inclusion of carbon (C) contributes to imparting etching characteristics similar to those of chromium carbide (CrN), which has a relatively low density and is easily etched by dry etching using a chlorine (Cl)-based gas containing oxygen (O), to a material containing chromium (Cr). Therefore, the second layer is provided as a layer containing carbon (C). In addition, the inclusion of oxygen (O) in the light shielding film contributes to improving an etching rate in dry etching using a chlorine (Cl)-based gas containing oxygen (O). Furthermore, in a case where a light shielding film pattern is formed from the light shielding film by dry etching using a chlorine (Cl)-based gas containing oxygen (O), it is preferable that a larger amount of oxygen (O) is supplied from the light shielding film in order to assist in processing for forming a minute space pattern by plasma, and thus the inclusion of oxygen (O) is effective.

The second layer contains chromium (Cr), oxygen (O), nitrogen (N), and carbon (C). Specifically, a material composed of chromium (Cr), oxygen (O), nitrogen (N), and carbon (C) is preferable as a material forming the second layer.

In the second layer, a chromium (Cr) content is preferably 30 atom% or more, more preferably 32 atom% or more, and is preferably 45 atom% or less, more preferably 43 atom% or less. In the second layer, an oxygen (O) content is preferably 28 atom% or more, more preferably 30 atom% or more, and is preferably 40 atom% or less, more preferably 38 atom% or less. In the second layer, a nitrogen (N) content is preferably 12 atom% or more, more preferably 14 atom% or more, and is preferably 24 atom% or less, more preferably 22 atom% or less. In the second layer, a carbon (C) content is preferably 5 atom% or more, more preferably 7 atom% or more, and is preferably 15 atom% or less, more preferably 12 atom% or less.

The second layer is preferably formed to be relatively thick among the first layer, the second layer, the third layer, and the fourth layer, from the viewpoint of obtaining the light shielding property (optical density (OD)) required throughout the light shielding film because the second layer has a relatively high optical density (OD) per unit thickness, and from the viewpoint of shortening the time (clear time) for etching the entire light shielding film to thin the resist film used when manufacturing the phase shift mask from the phase shift mask blank because the second layer has a high etching rate. In addition, the thinner the second layer, the more effectively the sheet resistance reducing effect of the third layer to be described below can be obtained, allowing a material having relatively low conductivity (relatively high sheet resistance) as the material of the second layer. The thickness of the second layer is preferably 18 nm or more, more preferably 20 nm or more, and is preferably 24 nm or less, more preferably 20 nm or less.

When a phase shift mask is manufactured from the phase shift mask blank, a resist film is usually formed in contact with the light shielding film. In a case where the light shielding film has a high sheet resistance, when a pattern is drawn in the resist film using an electron beam, the surface layer of the light shielding film may be charged by the electron beam, shifting the irradiation position of the electron beam, and the electron beam may not be irradiated at a predetermined position. If the irradiation position of the electron beam is shifted, a pattern is not formed at the predetermined position, and as a result, a circuit of a device to be manufactured is not correctly formed. Therefore, the light shielding film preferably has a low sheet resistance.

When the first layer, the second layer, and the fourth layer are formed of a material containing chromium (Cr) and oxygen (O), a material containing chromium (Cr), oxygen (O), nitrogen (N), and carbon (C), and a material containing chromium (Cr), oxygen (O), and nitrogen (N), respectively, and have a relatively low chromium (Cr) content, their sheet resistances become relatively high. In addition, when the first layer, the second layer, and the fourth layer have an oxygen (O)-rich composition having a relatively high oxygen (O) content, the first layer, the second layer, and the fourth layer having an oxygen-rich composition have relatively high sheet resistances because chromium oxide (CrO) has a higher sheet resistance than chromium nitride (CrN).

Therefore, from the viewpoint of reducing the sheet resistance of the entire light shielding film, the third layer contains chromium (Cr) and nitrogen (N), with a relatively high chromium (Cr) content, and is free of oxygen (O) or has a relatively low oxygen (O) content. Even if the sheet resistances of the first layer, the second layer, and the fourth layer are relatively high, the sheet resistance of the entire light shielding film can be reduced by providing the third layer. Although the third layer may be provided on the fourth layer side (that is, the first layer, the second layer, the third layer, and the fourth layer may be arranged in this order from the side away from the transparent substrate) or the first layer side (that is, the first layer, the third layer, the second layer, and the fourth layer may be arranged in this order from the side away from the transparent substrate) with respect to the second layer, it is preferable that the third layer is provided on the fourth layer side with respect to the second layer from the viewpoint of the height of resolution when a resist film is formed on the light shielding film that is in contact with an aqueous solution containing sulfuric acid to form a micropattern.

The third layer contains chromium (Cr) and nitrogen (N). Nitrogen (N) can increase the sheet resistance as compared with oxygen (O), but chromium nitride (CrN) has a lower etching rate with respect to dry etching using a chlorine (Cl)-based gas containing oxygen (O) as compared with chromium oxide (CrO). Therefore, the third layer preferably contains oxygen (O) from the viewpoint of reducing the sheet resistance of the entire light shielding film, increasing the etching rate, shortening the time (clear time) for etching the entire light shielding film, and thinning the resist film used when manufacturing the phase shift mask from the phase shift mask blank. The third layer may contain carbon (C) in a small amount, but is preferably free of carbon (C). Specifically, the material forming the third layer may be a material composed of chromium (Cr) and nitrogen (N), a material composed of chromium (Cr), nitrogen (N), and carbon (C), a material composed of chromium (Cr), oxygen (O), and nitrogen (N), or a material composed of chromium (Cr), oxygen (O), nitrogen (N), and carbon (C), and the material composed of chromium (Cr), oxygen (O), and nitrogen (N) is preferable.

In the third layer, a chromium (Cr) content is preferably 50 atom% or more, more preferably 52 atom% or more, and is preferably 60 atom% or less, more preferably 58 atom% or less. In a case where the third layer contains oxygen (O), an oxygen (O) content is more than 0 atom%, preferably 6 atom% or more, more preferably 10 atom% or more, and preferably 30 atom% or less, more preferably 28 atom% or less. In the third layer, a nitrogen (N) content is preferably 20 atom% or more, more preferably 22 atom% or more, and is preferably 40 atom% or less, more preferably 38 atom% or less. In a case where the third layer contains carbon (C), a carbon (C) content is preferably less than 5 atom%, more preferably 3 atom% or less, and still more preferably 2 atom% or less.

The third layer is preferably formed to be relatively thin among the first layer, the second layer, the third layer, and the fourth layer from the viewpoint of shortening the time (clear time) for etching the entire light shielding film, but the third layer needs to have a certain degree of thickness from the viewpoint of lowering the sheet resistance of the entire light shielding film. The thickness of the third layer is preferably 1 nm or more, more preferably 2 nm or more, and is preferably 6 nm or less, more preferably 4 nm or less.

In the light shielding film, the total sheet resistance of all layers except the fourth layer (in a case where the laminated structure includes a first layer, a second layer, a third layer, and a fourth layer, three layers: the first layer, the second layer, and the third layer), preferably all layers (in a case where the laminated structure includes a first layer, a second layer, a third layer, and a fourth layer, four layers: the first layer, the second layer, the third layer, and the fourth layer), in the laminated structure is preferably 350 kΩ/□ or less, more preferably 300 kΩ/□ or less, and still more preferably 250 kΩ/□ or less.

It is preferable that, the light shielding film, in particular, the light shielding film pattern, is used as a hard mask for etching the phase shift film, and then a part of the light shielding film pattern is left on the phase shift film to form a phase shift mask, specifically, the light shielding film pattern is left in contact with the phase shift film outside a region where the circuit pattern of the phase shift film pattern is formed (effective region) to form a phase shift mask as a light shielding portion at an outer peripheral edge portion of the phase shift mask.

In a case where the light shielding film forms the light shielding portion (light shielding film pattern) at the outer peripheral edge portion of the phase shift mask, a total optical density (OD) of the phase shift film and the light shielding film with respect to exposure light (specifically, light having a wavelength of 200 nm or less, such as ArF excimer laser (having a wavelength of 193 nm)) is preferably more than 2, more preferably 2.5 or more, and still more preferably 3 or more. For example, in a case where the phase shift film has a transmittance of 6% or more and 30% or less with respect to exposure light (an optical density (OD) of 0.53 or more and 1.22 or less), in order to make the total optical density (OD) of the phase shift film and the light shielding film 3 or more, the light shielding film needs to have an optical density (OD) of 1.78 or more with respect to exposure light. Note that the upper limit of the optical density (OD) of the light shielding film with respect to the exposure light is usually 3.2 or less.

The thickness of the light shielding film (the thickness of the entire light shielding film) is preferably 38 nm or more, more preferably 44 nm or more, and is preferably 70 nm or less, more preferably 65 nm or less, still more preferably 62 nm or less. In particular, in a case where the light shielding portion (light shielding film pattern) is formed in the light shielding film at the outer peripheral edge portion of the phase shift mask, the thickness of the light shielding film (the thickness of the entire light shielding film) is preferably 48 nm or more, and is preferably 54 nm or less.

The phase shift mask blank of the present invention may further include a resist film in contact with a side of the light shielding film away from the transparent substrate. The resist film may be an electron beam resist drawn with an electron beam or a photoresist drawn with light, and in particular, a chemically amplified resist is preferable. The chemically amplified resist may be either positive or negative, and may, for example, contain a base resin such as a hydroxystyrene-based resin or a (meth)acrylic acid-based resin, and an acid generator, with a crosslinker, a quencher, a surfactant, or the like added as necessary. The resist film has a thickness of preferably 200 nm or less, and more preferably 150 nm or less, from the viewpoint of preventing the resist pattern from collapsing during a developing process or a rinsing process after the development when forming a fine pattern. If the resist film is too thin, the resist film may not be formed with a stable thickness. Therefore, the thickness of the resist film is preferably 40 nm or more, and more preferably 50 nm or more.

The formation of the phase shift film and the light shielding film (the layers constituting the light shielding film) is not particularly limited, but it is preferable to use a sputtering method to form them because the sputtering method has good controllability and makes it easy to form a film having predetermined characteristics. The sputtering method is not particularly limited, and DC sputtering, RF sputtering, or the like can be applied.

In a case where the phase shift film is formed of a material containing silicon (Si) and free of carbon (C), a silicon (Si) target can be used as a sputtering target, and if necessary, a target of a transition metal, preferably a transition metal (Me) other than chromium (Cr), or a target containing silicon (Si) and a transition metal, preferably a transition metal (Me) other than chromium (Cr), can be used. The sputtering may be co-sputtering using a plurality of types of targets. In this case, the co-sputtering can be performed using a silicon (Si) target and a target of a transition metal, preferably a transition metal (Me) other than chromium (Cr), using a plurality of targets containing silicon (Si) and a transition metal, preferably a transition metal (Me) other than chromium (Cr), and having different compositions (in which some or all of the constituent elements are different, or the constituent elements are the same but their concentrations are different), or using a silicon (Si) target or a target of a transition metal, preferably a transition metal (Me) other than chromium (Cr), and a target containing silicon (Si) and a transition metal, preferably a transition metal (Me) other than chromium (Cr).

On the other hand, in a case where the light shielding film is formed of a material containing chromium (Cr), oxygen (O), nitrogen (N), and carbon (C) (in a case where the layers constituting the light shielding film are formed), a chromium (Cr) target can be used as a sputtering target.

The power to be input to the sputtering target may be appropriately set depending on the size of the sputtering target, cooling efficiency, controllability in film formation, etc., and usually, the power per area of the sputtering surface of the sputtering target may be 0.1 to 10 W/cm².

In a case where the phase shift film is formed of a material composed of only silicon (Si) or a material composed of only silicon (Si) and a transition metal, only a noble gas such as a helium gas (He), a neon gas (Ne), or an argon gas (Ar) is used as a sputtering gas. On the other hand, in a case where the phase shift film is formed of a material containing one or both of oxygen (O) and nitrogen (N), the sputtering is preferably reactive sputtering. In this case, a noble gas such as a helium gas (He gas), a neon gas (Ne gas), or an argon gas (Ar gas), and a reactive gas are used as the sputtering gas. For example, in a case where the phase shift film contains oxygen (O), an oxygen gas (O₂ gas) may be used as the reactive gas, and in a case where the phase shift film contains nitrogen (N), a nitrogen gas (N₂ gas) may be used as the reactive gas. In addition, in a case where the phase shift film contains both oxygen (O) and nitrogen (N), an oxygen gas (O₂ gas) and a nitrogen gas (N₂ gas) may be simultaneously used as the reactive gas, or a nitrogen oxide gas such as a nitrogen monoxide gas (NO gas), a nitrogen dioxide gas (NO₂ gas), or a nitrous oxide gas (N₂O gas) may be used as the reactive gas.

On the other hand, in a case where the light shielding film is formed of a material containing chromium (Cr), oxygen (O), nitrogen (N), and carbon (C) (in a case where the layers constituting the light shielding film are formed), the sputtering is preferably reactive sputtering. In this case, a noble gas such as a helium gas (He gas), a neon gas (Ne gas), or an argon gas (Ar gas), and a reactive gas are used as the sputtering gas. For example, in a case where the layer constituting the light shielding film contains oxygen (O), an oxygen gas (O₂ gas) may be used as the reactive gas, and in a case where the layer constituting the light shielding film contains nitrogen (N), a nitrogen gas (N₂ gas) may be used as the reactive gas. In a case where the layer constituting the light shielding film contains both oxygen (O) and nitrogen (N), an oxygen gas (O₂ gas) and a nitrogen gas (N₂ gas) may be simultaneously used as the reactive gas, or a nitrogen oxide gas such as a nitrogen monoxide gas (NO gas), a nitrogen dioxide gas (NO₂ gas), or a nitrous oxide gas (N₂O gas) may be used as the reactive gas. In a case where the layer constituting the light shielding film contains carbon (C), a carbon oxide gas such as a carbon monoxide gas (CO gas) or a carbon dioxide gas (CO₂ gas) may be used as the reactive gas.

The pressure during film formation may be appropriately set in consideration of film stress, chemical resistance, cleaning resistance, etc., and is usually preferably 0.01 Pa or more, more preferably 0.03 Pa or more, and is preferably 1 Pa or less, more preferably 0.3 Pa or less, to improve chemical resistance. The flow rate of each gas may be appropriately set so as to obtain a desired composition, and may usually be 0.1 to 100 sccm.

In the process of manufacturing the phase shift mask blank, the transparent substrate or the transparent substrate and the film formed on the transparent substrate may be subjected to heat treatment. As a heat treatment method, infrared heating, resistance heating, or the like can be applied, and the treatment conditions are not particularly limited. The heat treatment can be performed, for example, in a gas atmosphere containing oxygen (O). The concentration of the gas containing oxygen (O) is not particularly limited, and can be, for example, 1 to 100 vol% in the case of oxygen gas (O₂ gas). The heat treatment temperature is preferably 200°C or higher, and more preferably 400°C or higher. Furthermore, in the process of manufacturing the phase shift mask blank, the film formed on the transparent substrate, particularly the light shielding film, may be subjected to ozone (O₃) treatment, plasma treatment, or the like, and the treatment conditions are not particularly limited. Either treatment can be performed for the purpose of increasing the concentration of the oxygen (O) in the surface portion of the film, and in that case, the treatment condition may be appropriately adjusted so as to obtain a predetermined concentration of oxygen (O). In a case where the film is formed by sputtering, the concentration of oxygen (O) in the surface portion of the film can be increased by adjusting the ratio between the noble gas and the gas (oxidizing gas) containing oxygen (O), such as an oxygen gas (O₂ gas), a carbon monoxide gas (CO gas), or a carbon dioxide gas (CO₂ gas), in the sputtering gas.

In the process of manufacturing the phase shift mask blank, a cleaning process may be performed to remove particles existing on the surface of the transparent substrate or the film formed on the transparent substrate. The cleaning can be performed using one or both of ultrapure water and functional water that is ultrapure water containing an ozone gas (O₃ gas), a hydrogen gas (H₂ gas), and the like. In addition, after the cleaning using ultrapure water containing a surfactant, further cleaning may be performed using one or both of ultrapure water and functional water. The cleaning can be performed while irradiating ultrasonic waves as necessary, and can also be combined with irradiation with UV light.

When a resist film is formed on the photomask blank of the present invention, the resist film formation method is not particularly limited, and a known method such as spin coating can be applied.

From the phase shift mask blank of the present invention, a phase shift mask can be manufactured by a general method without using a special development process or special dry etching. In addition, since an etching rate is high when the light shielding film is etched by dry etching using a chlorine (Cl)-based gas containing oxygen (O), and a time (clear time) for etching the entire light shielding film is short, a resist film is formed thin, so that a phase shift mask can be manufactured by a general method, and a fine line pattern is prevented from collapsing due to a collision of a developer or the like in a process of developing the resist film, so that a good resolution limit can be achieved in forming a line pattern of an assist pattern that assists the resolution of the main pattern of the phase shift mask.

From the phase shift mask blank of the present invention, it is possible to manufacture a phase shift mask having a circuit pattern of a phase shift film and having a light shielding portion (light shielding film pattern) at an outer peripheral edge portion which is a region where the circuit pattern of the phase shift mask is not formed. Specifically, a phase shift mask having a circuit pattern of a phase shift film in an effective region of the phase shift mask and having a light shielding portion (light shielding film pattern) at an outer peripheral edge portion of the phase shift mask can be manufactured by a method including the following steps (A) to (I).

First, a first resist film is formed on the light shielding film as necessary (step (A)). In a case where a resist film is not formed on the phase shift mask blank, a resist film is formed on the light shielding film in contact with the light shielding film in this step. In a case where a phase shift mask blank on which a resist film is formed is used, this step is not necessary. As the first resist film, a resist film similar to the above-described resist film included in the phase shift mask blank can be used, and the first resist film can also have a thickness similar to that of the above-described resist film included in the phase shift mask blank. The resist film formation method is not particularly limited, and a known method such as spin coating can be applied.

Next, a first resist pattern is formed by patterning the first resist film (step (B)). The first resist pattern can be formed by drawing a pattern on the resist film using light or an electron beam and developing the pattern using a known method.

Next, a light shielding film pattern is formed by patterning the light shielding film by dry etching using a chlorine (Cl)-based gas containing oxygen (O), using the first resist pattern as an etching mask (step (C)).

Next, a phase shift film pattern is formed by patterning the phase shift film by dry etching using a fluorine (F)-based gas, using the light shielding film pattern as an etching mask (step (D)).

Next, the first resist pattern is removed (step (E)). The first resist pattern can be removed by cleaning with a sulfuric acid/hydrogen peroxide solution (a mixed solution of sulfuric acid and hydrogen peroxide).

Next, a second resist film is formed on the light shielding film pattern (step (F)). In this case, the second resist film is formed on the light shielding film pattern in contact with the light shielding film pattern, and the second resist film is also formed on and in contact with a portion exposed by removing the phase shift film (a transparent substrate or another film formed between the transparent substrate and the phase shift film as necessary). As the second resist film, a resist film similar to the above-described resist film included in the phase shift mask blank can be used, and in particular, a resist film for laser drawing is suitable. The second resist film preferably has a thickness of 250 nm or more and 500 nm or less.

Next, a second resist pattern is formed on an outer peripheral edge portion located outside a region where the circuit pattern of the phase shift film is formed by patterning the second resist film (step (G)). The second resist pattern can be formed by drawing a pattern on the resist film using light or an electron beam and developing the pattern using a known method.

Next, the light shielding film pattern in the region where the circuit pattern of the phase shift film is formed (effective region) is removed by dry etching using a chlorine (Cl)-based gas containing oxygen (O), using the second resist pattern as an etching mask (step (H)).

Next, the second resist pattern is removed (step (I)). The second resist pattern can be removed by cleaning with a sulfuric acid/hydrogen peroxide solution (a mixed solution of sulfuric acid and hydrogen peroxide).

The phase shift film pattern of the phase shift mask preferably has optical characteristics (phase difference, transmittance, etc.) that hardly change even when the phase shift film comes into contact with an aqueous solution containing sulfuric acid used for removing the resist film used to form a light shielding portion (light shielding film pattern) at the outer peripheral edge portion of the phase shift film and for cleaning the phase shift mask in the process of manufacturing the phase shift mask from the phase shift mask blank.

Therefore, when the phase shift film comes into contact with the aqueous solution containing sulfuric acid to remove the resist film pattern as in the above-described step (I), the amount of change in phase difference of the phase shift film (the amount of change with respect to the value set for the phase difference of the phase shift film in the phase shift mask blank state) is preferably 0.2 degrees or less, more preferably 0.1 degrees or less, and still more preferably 0.03 degrees or less, and the amount of change in transmittance of the phase shift film (the amount of change with respect to the value set for the transmission of the phase shift film in the phase shift mask blank state) is preferably 0.05% (percent points) or less, and more preferably 0.01% (percent points) or less.

In addition, when the phase shift film comes into contact with the aqueous solution containing sulfuric acid to clean the phase shift mask, specifically, when the phase shift mask is cleaned (at 100°C and for 30 minutes) with a sulfuric acid/hydrogen peroxide solution (a mixed solution of sulfuric acid : hydrogen peroxide = 3:1 (volume ratio)), the amount of change in phase difference of the phase shift film is preferably 0.3 degrees or less, more preferably 0.2 degrees or less, and still more preferably 0.14 degrees or less, and the amount of change in transmittance of the phase shift film is preferably 0.10% (percent points) or less, more preferably 0.05% (percent points) or less, and still more preferably 0.04% (percent points) or less. Note that the above-described amounts of change in phase difference and transmittance mean a difference in phase difference and a difference in transmittance.

The phase shift mask of the present invention is particularly effective in exposure for transferring a pattern to a photoresist film formed on the wafer (substrate to be processed) using exposure light having a wavelength of 200 nm or less, such as ArF excimer laser (having a wavelength of 193 nm), in photolithography for forming a pattern with a half pitch of 50 nm or less, preferably 30 nm or less, more preferably 20 nm or less, and still more preferably 10 nm or less on a wafer (substrate to be processed).

Using the phase shift mask manufactured from the phase shift mask blank of the present invention, the phase shift mask pattern (photomask pattern) can be irradiated with exposure light to transfer the photomask pattern to a photoresist film formed on the wafer (substrate to be processed), which is an object to be exposed to by the photomask pattern. The irradiation with exposure light may be used by exposure under dry conditions or by immersion exposure, and can particularly be suitably used when a photomask pattern is exposed to a wafer (substrate to be processed) of 300 mm or more by immersion exposure.

The exposure light from the wafer exposure device is irradiated onto the phase shift mask, and the exposure light is shielded in the light shielding film pattern. In the circuit pattern (halftone phase shift film pattern), a part of the exposure light is shielded in a line pattern, and the shielded light is transmitted through the transparent substrate and irradiated onto the photoresist film on the wafer (substrate to be processed) in the space pattern. It is preferable that the phase shift mask can be used for a long period of time without generating a haze even when the amount of exposure light with which the phase shift film is irradiated is accumulated. From this viewpoint, it is preferable that the phase shift mask does not generate a haze until the cumulative amount of irradiation of exposure light reaches 40 kJ/cm², and it is more preferable that the phase shift mask does not generate a haze until the cumulative amount of irradiation of exposure light reaches 50 kJ/cm². It is preferable that this haze, which is one or both of a haze caused by the above-described ammonium sulfate ((NH₄)₂SO₄) or the like and a haze caused by the above-described chromium oxide (CrO) or the like, is not generated until the irradiation amount of exposure light reaches the above-described range.

### EXAMPLES

Hereinafter, the present invention is specifically described with reference to Examples and Comparative Examples, but the present invention is not limited to the following Examples.

In each of the Examples and Comparative Examples, a phase shift mask blank (halftone phase shift mask blank) was manufactured by laminating a phase shift film (halftone phase shift film) formed of a material containing silicon (Si) and free of carbon (C) and a light shielding film formed of a material containing chromium (Cr), oxygen (O), nitrogen (N), and carbon (C) on a transparent substrate made of synthetic quartz glass having a size of 152 mm square and about 6 mm thick.

### Examples 1 to 10

First, a single-layer phase shift film (having a thickness of 65 nm) of silicon nitride (SiN) having a phase difference of 177 degrees and a transmittance of 6% (an optical density (OD) of 1.22) with respect to ArF excimer laser (having a wavelength of 193 nm) was formed on the transparent substrate by adjusting the power applied to a target using a silicon (Si) target as the target, and performing sputtering in a gas atmosphere containing argon and nitrogen using an argon gas (Ar gas) and a nitrogen gas (N₂ gas) as sputtering gases. The composition of the phase shift film and the zeta potentials at pH 3, 4, 5 and 6 are shown in Table 1. The composition of the phase shift film was measured by X-ray photoelectron spectroscopy (the same applies to the following Examples). The zeta potentials were measured using an electrophoretic light scattering photometer (the same applies to the following Examples).

Next, a phase shift mask blank was obtained by forming a light shielding film on the phase shift film, the light shielding film consisting of a first layer, a second layer, a third layer, and a fourth layer from a side away from the transparent substrate, with the first layer being formed of chromium oxynitride (CrON), the second layer being formed of chromium oxynitride carbide (CrONC), the third layer being formed of chromium oxynitride (CrON), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the third layer, the second layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1. The composition of each layer of the light shielding film was measured by X-ray photoelectron spectroscopy (the same applies to the following Examples). In addition, the sheet resistance was measured by a four-point probe method (the same applies to the following Examples).

### Example 11

First, a single-layer phase shift film (having a thickness of 69 nm) of molybdenum silicon oxynitride (MoSiON) having a phase difference of 177 degrees and a transmittance of 6% (an optical density (OD) of 1.22) with respect to ArF excimer laser (having a wavelength of 193 nm) was formed on the transparent substrate by adjusting the power applied to targets using a silicon (Si) target and a molybdenum (Mo) target as the targets, and performing sputtering in a gas atmosphere containing argon, oxygen, and nitrogen using an argon gas (Ar gas), an oxygen gas (O₂ gas), and a nitrogen gas (N₂ gas) as sputtering gases. The composition of the phase shift film and the zeta potentials at pH 3, 4, 5 and 6 are shown in Table 1.

Next, a phase shift mask blank was obtained by forming a light shielding film similar to that in Example 1 on the phase shift film by a method similar to that in Example 1. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1.

### Example 12

First, a phase shift film similar to that in Example 11 was formed on the transparent substrate by a method similar to that in Example 11. The composition of the phase shift film and the zeta potentials at pH 3, 4, 5 and 6 are shown in Table 1.

Next, a phase shift mask blank was obtained by forming a light shielding film on the phase shift film, the light shielding film consisting of a first layer, a second layer, a third layer, and a fourth layer from a side away from the transparent substrate, with the first layer being formed of chromium oxide (CrO), the second layer being formed of chromium oxynitride carbide (CrONC), the third layer being formed of chromium oxynitride (CrON), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the third layer, the second layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1.

### Example 13

First, a phase shift film similar to that in Example 11 was formed on the transparent substrate by a method similar to that in Example 11. The composition of the phase shift film and the zeta potentials at pH 3, 4, 5 and 6 are shown in Table 1.

Next, a phase shift mask blank was obtained by forming a light shielding film on the phase shift film, the light shielding film consisting of a first layer, a second layer, a third layer, and a fourth layer from a side away from the transparent substrate, with the first layer being formed of chromium oxynitride (CrON), the second layer being formed of chromium oxynitride carbide (CrONC), the third layer being formed of chromium nitride (CrN), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the third layer, the second layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1.

### Example 14

First, a phase shift film similar to that in Example 11 was formed on the transparent substrate by a method similar to that in Example 11. The composition of the phase shift film and the zeta potentials at pH 3, 4, 5 and 6 are shown in Table 1.

Next, a phase shift mask blank was obtained by forming a light shielding film on the phase shift film, the light shielding film consisting of a first layer, a second layer, a third layer, and a fourth layer from a side away from the transparent substrate, with the first layer being formed of chromium oxynitride carbide (CrONC), the second layer being formed of chromium oxynitride carbide (CrONC), the third layer being formed of chromium oxynitride (CrON), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the third layer, the second layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1.

### Example 15

First, a phase shift film similar to that in Example 11 was formed on the transparent substrate by a method similar to that in Example 11. The composition of the phase shift film and the zeta potentials at pH 3, 4, 5 and 6 are shown in Table 1.

Next, a phase shift mask blank was obtained by forming a light shielding film on the phase shift film, the light shielding film consisting of a first layer, a second layer, a third layer, and a fourth layer from a side away from the transparent substrate, with the first layer being formed of chromium oxynitride (CrON), the second layer being formed of chromium oxynitride carbide (CrONC), the third layer being formed of chromium oxynitride carbide (CrONC), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the third layer, the second layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1.

### Example 16

First, a phase shift film similar to that in Example 1 was formed on the transparent substrate by a method similar to that in Example 1. The composition of the phase shift film and the zeta potentials at pH 3, 4, 5 and 6 are shown in Table 1.

Next, a phase shift mask blank was obtained by forming a light shielding film on the phase shift film, the light shielding film consisting of a first layer, a third layer, a second layer, and a fourth layer from a side away from the transparent substrate, with the first layer being formed of chromium oxynitride (CrON), the third layer being formed of chromium oxynitride (CrON), the second layer being formed of chromium oxynitride carbide (CrONC), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the second layer, the third layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1.

### Example 17

First, a phase shift film similar to that in Example 11 was formed on the transparent substrate by a method similar to that in Example 11. The composition of the phase shift film and the zeta potentials at pH 3, 4, 5 and 6 are shown in Table 1.

Next, a phase shift mask blank was obtained by forming a light shielding film on the phase shift film, the light shielding film consisting of a first layer, a third layer, a second layer, and a fourth layer from a side away from the transparent substrate, with the first layer being formed of chromium oxynitride (CrON), the third layer being formed of chromium oxynitride (CrON), the second layer being formed of chromium oxynitride carbide (CrONC), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the second layer, the third layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 1.

### Comparative Example 1

First, a single-layer phase shift film (having a thickness of 75 nm) of molybdenum silicon oxynitride (MoSiON) having a phase difference of 177 degrees and a transmittance of 6% (an optical density (OD) of 1.22) with respect to ArF excimer laser (having a wavelength of 193 nm) was formed on the transparent substrate by adjusting the power applied to targets using a silicon (Si) target and a molybdenum (Mo) target as the targets, and performing sputtering in a gas atmosphere containing argon, oxygen, and nitrogen using an argon gas (Ar gas), an oxygen gas (O₂ gas), and a nitrogen gas (N₂ gas) as sputtering gases. The composition of the phase shift film and the zeta potentials at pH 3, 4, 5 and 6 are shown in Table 2.

Next, a phase shift mask blank was obtained by forming a single-layer light shielding film of chromium oxynitride carbide (CrONC) on the phase shift film by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide. The composition and thickness of the light shielding film, the optical density (OD) of the light shielding film with respect to ArF excimer laser (having a wavelength of 193 nm), and the sheet resistance of the light shielding film are shown in Table 2.

### Comparative Example 2

First, a phase shift film similar to that in Comparative Example 1 was formed on the transparent substrate by a method similar to that in Comparative Example 1. The composition of the phase shift film and the zeta potentials at pH 3, 4, 5 and 6 are shown in Table 2.

Next, a phase shift mask blank was obtained by forming a light shielding film on the phase shift film, the light shielding film consisting of a first layer, a second layer, a third layer, and a fourth layer from a side away from the transparent substrate, with the first layer being formed of chromium oxynitride (CrON), the second layer being formed of chromium oxynitride carbide (CrONC), the third layer being formed of chromium oxynitride (CrON), and the fourth layer being formed of chromium oxynitride carbide (CrONC), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the third layer, the second layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 2.

### Comparative Example 3

First, a phase shift film similar to that in Example 1 was formed on the transparent substrate by a method similar to that in Example 1. The composition of the phase shift film and the zeta potentials at pH 3, 4, 5 and 6 are shown in Table 2.

Next, a phase shift mask blank was obtained by forming a light shielding film similar to that in Comparative Example 1 on the phase shift film by a method similar to that in Comparative Example 1. The composition and thickness of each layer of the light shielding film, the optical density (OD) of the light shielding film with respect to ArF excimer laser (having a wavelength of 193 nm), and the sheet resistance of the light shielding film are shown in Table 2.

### Comparative Example 4

First, a phase shift film similar to that in Comparative Example 1 was formed on the transparent substrate by a method similar to that in Comparative Example 1. The composition of the phase shift film and the zeta potentials at pH 3, 4, 5 and 6 are shown in Table 2.

Next, a phase shift mask blank was obtained by forming a light shielding film on the phase shift film, the light shielding film consisting of two layers: an upper layer and a lower layer from a side away from the transparent substrate, with the upper layer being formed of chromium oxynitride carbide (CrONC), and the lower layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the lower layer and the upper layer in this order. The composition and thickness of each layer of the light shielding film, the thickness and optical density (OD) of the entire light shielding film to the ArF excimer laser (having a wavelength of 193 nm), and the sheet resistance of the light shielding film are shown in Table 2.

### Comparative Example 5

First, a phase shift film similar to that in Comparative Example 1 was formed on the transparent substrate by a method similar to that in Comparative Example 1. The composition of the phase shift film and the zeta potentials at pH 3, 4, 5 and 6 are shown in Table 2.

Next, a phase shift mask blank was obtained by forming a light shielding film on the phase shift film, the light shielding film consisting of three layers: an upper layer, a middle layer, and a lower layer from a side away from the transparent substrate, with the upper layer being formed of chromium oxynitride (CrON), the middle layer being formed of chromium oxynitride carbide (CrONC), and the lower layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the lower layer, the middle layer, and the upper layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 2.

### Comparative Example 6

First, a phase shift film similar to that in Example 1 was formed on the transparent substrate by a method similar to that in Example 1. The composition of the phase shift film and the zeta potentials at pH 3, 4, 5 and 6 are shown in Table 2.

Next, a phase shift mask blank was obtained by forming a light shielding film on the phase shift film, the light shielding film consisting of a first layer, a second layer, a third layer, and a fourth layer from a side away from the transparent substrate, with the first layer being formed of chromium oxynitride (CrON), the second layer being formed of chromium oxynitride carbide (CrONC), the third layer being formed of chromium oxynitride carbide (CrONC), and the fourth layer being formed of chromium oxynitride (CrON), by adjusting the power applied to a target using a chromium (Cr) target as the target, adjusting the ratio between sputtering gases using an argon gas (Ar gas), an oxygen gas (O₂ gas), a nitrogen gas (N₂ gas), and a carbon dioxide gas (CO₂ gas) as the sputtering gases, and performing sputtering in a gas atmosphere containing argon, oxygen, nitrogen, and carbon dioxide with respect to the fourth layer, the third layer, the second layer, and the first layer in this order. The composition and thickness of each layer of the light shielding film, the thickness of the entire light shielding film, the optical density (OD) of the light shielding film with respect to ArF excimer laser (having a wavelength of 193 nm), and the sheet resistance of the light shielding film are shown in Table 2.

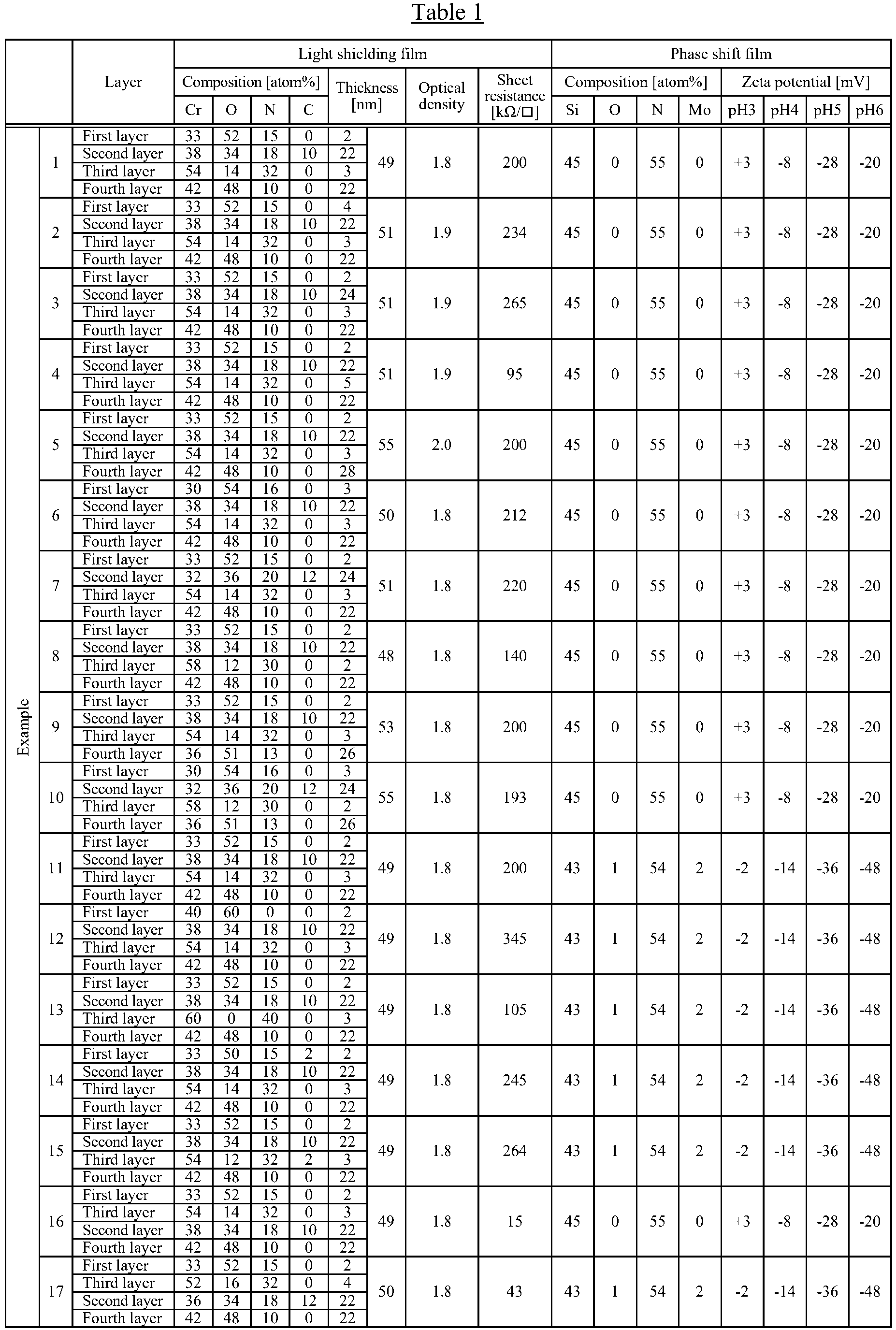

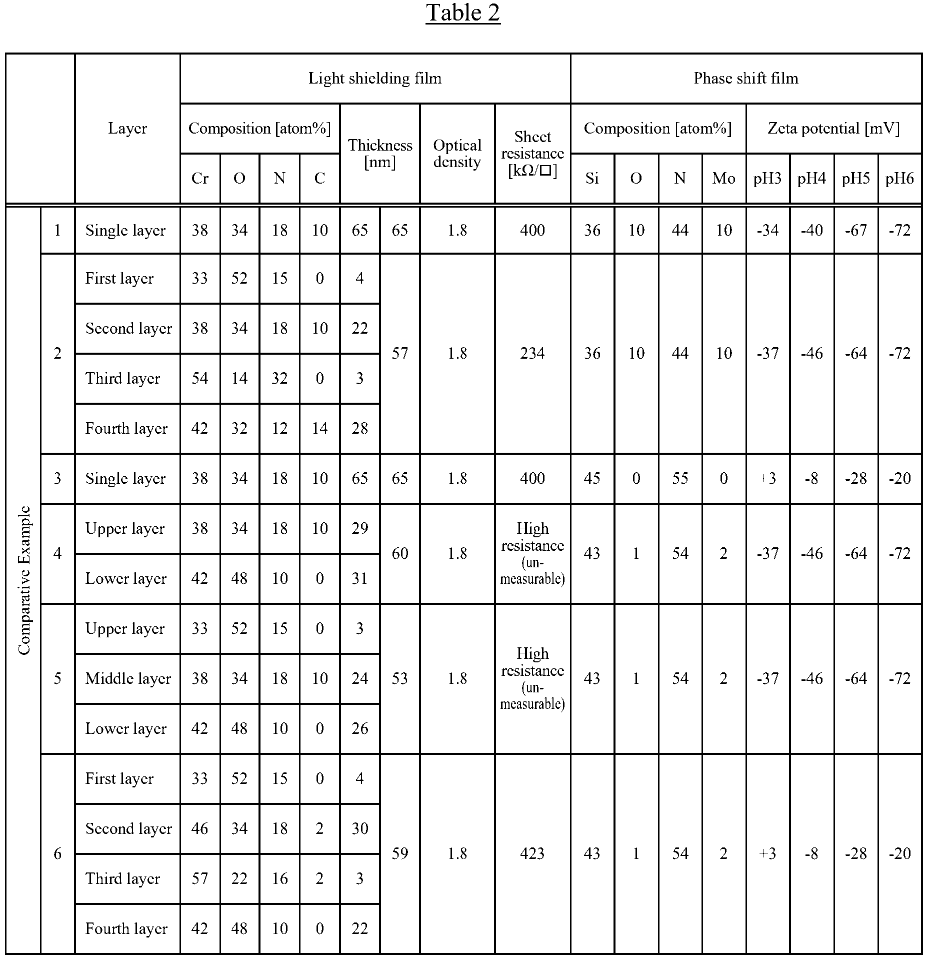

Next, using the phase shift mask blank obtained in each of the Examples and Comparative Examples, dry etching using a chlorine (Cl)-based gas containing oxygen (O) was performed under the following condition 1, and the clear time (the time until the light shielding film disappears by dry etching and the end point is detected) was measured. The clear time and the etching rate, which is obtained from the thickness of the light shielding film and the clear time, are shown in Table 3.

### <Condition 1: Dry Etching Using Chlorine (Cl)-Based Gas Containing Oxygen (O)>

| | |
|---|---|
| Apparatus: | inductively coupled plasma (ICP) type |
| Gas: | Cl₂ gas (150 sccm) + O₂ gas (50 sccm) |
| Gas pressure: | 3.0 mTorr (0.40 Pa) |
| ICP power: | 350 W |

**Table 3**

| | | Clear time [see] | Etching rate [nm/sec] |
|---|---|---|---|
| Example | 1 | 100 | 0.49 |
| | 2 | 108 | 0.47 |
| | 3 | 104 | 0.49 |
| | 4 | 108 | 0.47 |
| | 5 | 110 | 0.50 |
| | 6 | 102 | 0.49 |
| | 7 | 96 | 0.53 |
| | 8 | 105 | 0.46 |
| | 9 | 103 | 0.51 |
| | 10 | 102 | 0.54 |
| | 11 | 100 | 0.49 |
| | 12 | 98 | 0.50 |
| | 13 | 102 | 0.49 |
| | 14 | 97 | 0.51 |
| | 15 | 97 | 0.51 |
| | 16 | 100 | 0.49 |
| | 17 | 97 | 0.52 |
| Comparative Example | 1 | 111 | 0.59 |
| | 2 | 90 | 0.63 |
| | 3 | 111 | 0.59 |
| | 4 | 91 | 0.66 |
| | 5 | 97 | 0.55 |
| | 6 | 146 | 0.40 |

In the light shielding film of each of the Examples, the fourth layer is free of carbon (C), but the second layer contains carbon (C), and the oxygen (O) contents of the first layer and the fourth layer are relatively high. In particular, in each of Example 7 and Example 10, the chromium (Cr) content of the second layer is relatively low, and the oxygen (O) content of the second layer is relatively high. Therefore, as shown in Table 3, even though the light shielding film includes a third layer having a relatively high nitrogen (N) content, the time (clear time) for etching the entire light shielding film is shorter than that in Comparative Example 1. In addition, in the light shielding film of each of the Examples, the light shielding property (optical density (OD)) required throughout the light shielding film is also secured.

Next, a phase shift mask was manufactured using another phase shift mask blank obtained in each of the Examples and Comparative Examples.

First, a positive chemically-amplified electron beam resist was spin-coated on the light shielding film to form a first resist film having a thickness of 120 nm (step (A)).

Next, a total of 100 million line and space patterns having a long side dimension of 100,000 nm, a short side line dimension of 200 nm, and a short side space dimension of 200 nm were drawn at a dose of 35 µC/cm², using an electron beam lithography apparatus. In addition, a space pattern of 10 mm × 10 mm was drawn in order to measure a phase difference and a transmittance. Next, a heat treatment (post exposure bake (PEB)) was performed at 110°C for 14 minutes using a heat treatment device. Next, a development process was performed by paddle development for 80 seconds to form a first resist pattern (step (B)).

Next, using the first resist pattern as an etching mask, the light shielding film was patterned by dry etching using a chlorine (Cl)-based gas containing oxygen (O) under the following condition 2 to form a light shielding film pattern (step (C)).

### <Condition 2: Dry Etching Using Chlorine (Cl)-Based Gas Containing Oxygen (O)>

| | |
|---|---|
| Apparatus: | inductively coupled plasma (ICP) type |
| Gas: | Cl₂ gas (150 sccm) + O₂ gas (50 sccm) |
| Gas pressure: | 3.0 mTorr (0.40 Pa) |
| ICP power: | 350 W |
| Over-etching time: | 100% (etching time: 200% of clear time) |

Next, using the light shielding film pattern as an etching mask, the phase shift film was patterned by dry etching using a fluorine (F)-based gas under the following condition 3 to form a phase shift film pattern (step (D)).

### <Condition 3: Dry etching using fluorine (F)-based gas>

| | |
|---|---|
| Apparatus: | inductively coupled plasma (ICP) type |
| Gas: | SF₆ gas + He gas |
| Gas pressure: | 4.0 mTorr (0.53 Pa) |
| ICP power: | 400 W |

Next, the first resist pattern was removed by performing cleaning (at 100°C and for 6 minutes) with a sulfuric acid/hydrogen peroxide solution (a mixed solution of sulfuric acid : hydrogen peroxide = 3:1 (volume ratio)) (step (E)).

Next, a resist for laser drawing was spin-coated on the transparent substrate exposed by removing the light shielding film pattern and the phase shift film to form a second resist film having a thickness (a thickness on the transparent substrate) of 465 nm (step (F)).

Next, an effective region including the circuit pattern of the phase shift film was drawn, using a laser drawing device, so that the second resist film remained in a portion located at an outer peripheral edge portion of the transparent substrate. Next, a heat treatment (post exposure bake (PEB)) was performed at 110°C for 20 minutes using a heat treatment device. Next, a development process was performed for 200 seconds by spray development to form a second resist pattern on an outer peripheral edge portion located outside a region where the circuit pattern of the phase shift film was formed (step (G)).

Next, using the second resist pattern as an etching mask, the light shielding film pattern in the region where the circuit pattern of the phase shift film was formed was removed by dry etching using a chlorine (Cl)-based gas containing oxygen (O) under the above-described condition 2 (step (H)).

Next, the second resist pattern was removed by performing cleaning (at 100°C and for 6 minutes) with a sulfuric acid/hydrogen peroxide solution (a mixed solution of sulfuric acid : hydrogen peroxide = 3:1 (volume ratio)) (step (I)), thereby obtaining a phase shift mask.

Next, a phase difference and a transmittance were measured between a space pattern of 10 mm × 10 mm formed on the obtained phase shift mask and the surrounding phase shift film pattern using a phase difference and transmittance measuring device, and differences thereof from the values set for the phase difference and the transmittance of the phase shift film (differences between the set values and the measured values for the phase difference and the transmittance (differences before and after manufacturing)) were obtained. The results are shown in Table 4.

Next, the phase shift mask was cleaned (at 100°C and for 6 minutes) with a sulfuric acid/hydrogen peroxide solution (a mixed solution of sulfuric acid : hydrogen peroxide = 3:1 (volume ratio)) repeatedly five times. Next, a phase difference and a transmittance were measured between a space pattern of 10 mm × 10 mm formed on the obtained phase shift mask and the surrounding phase shift film pattern using a phase difference and transmittance measuring device, and differences thereof from the phase difference and the transmittance before the phase shift film pattern was cleaned (differences in phase difference and transmittance before and after cleaning) were obtained. The results are shown in Table 4.

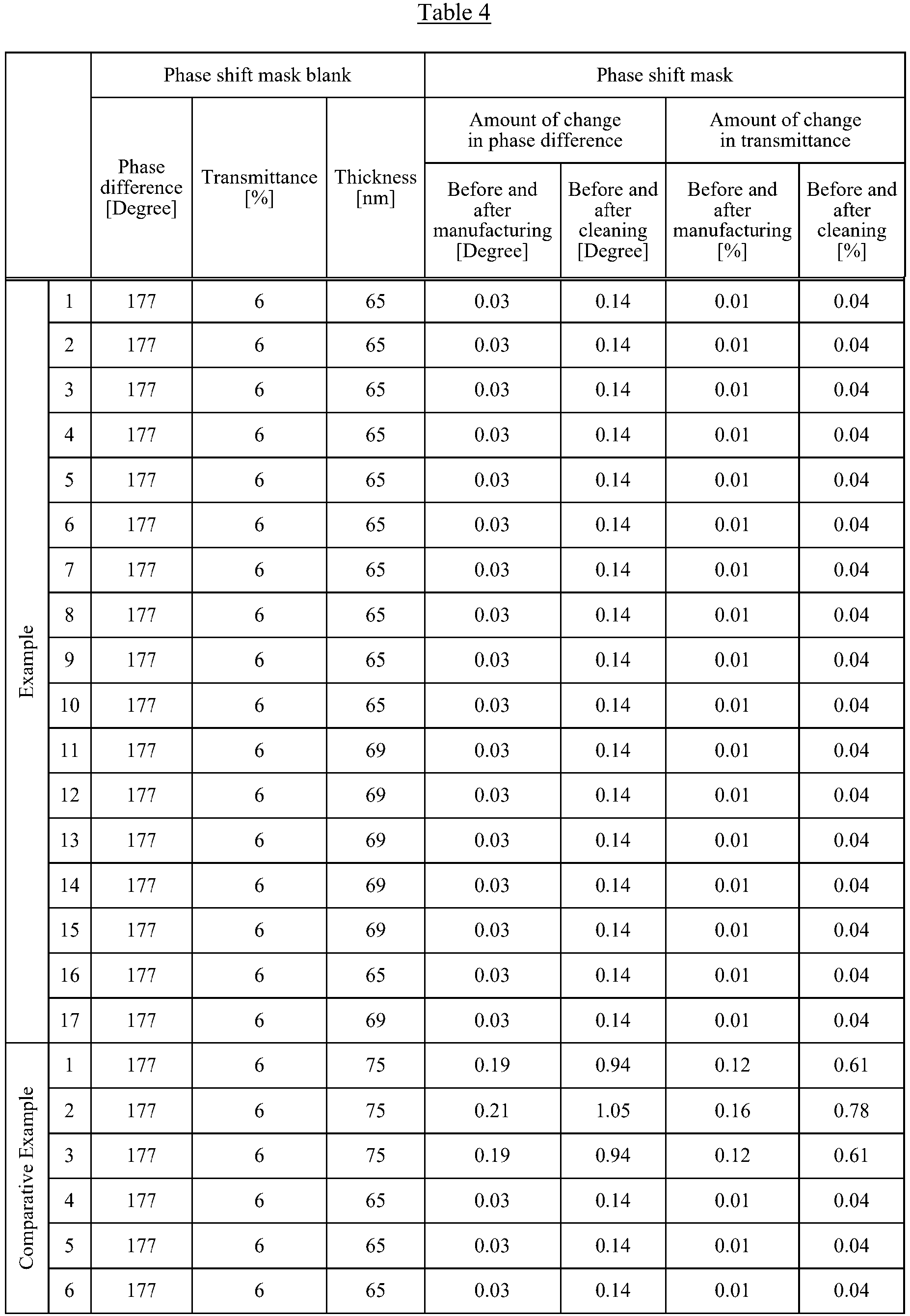

It was confirmed that changes in phase difference and transmittance of the phase shift film (phase shift film pattern) that had come into contact with a sulfuric acid/hydrogen peroxide solution were suppressed in a phase shift film pattern that was in contact with a layer free of carbon (C) of the light shielding film, as compared with a phase shift film pattern that was in contact with a layer containing carbon (C) of the light shielding film.

Next, the phase shift mask of which the amounts of change in phase difference and transmittance had been measured was placed in an exposure device, and a line and space pattern formed on the phase shift mask and having a long side dimension of 100,000 nm, a short side line dimension of 200 nm, and a short side space dimension of 200 nm was irradiated with ArF excimer laser (having a wavelength of 193 nm) under the following condition 4. Then, the phase shift mask was taken out from the exposure device every time the cumulative amount of irradiation reached 10 kJ/cm², 20 kJ/cm², 30 kJ/cm², 40 kJ/cm², or 50 kJ/cm² until a haze was detected, and it was evaluated using a mask pattern inspection device whether there is a defect in the line and space pattern. The composition of the defect was analyzed using TEM/EDX to identify a haze of ammonium sulfate ((NH₄)₂SO₄) and a haze of chromium oxide (CrO). The results are shown in Table 5.

### <Condition 4: Condition for Irradiation of ArF Excimer Laser (Wavelength of 193 nm)>

| | |
|---|---|
| Laser intensity: | 2.5 mJ/pulse/cm² |
| Laser frequency: | 1600 Hz |
| Laser irradiation area: | 5 mm × 5 mm |
| Temperature in exposure chamber (atmosphere in which phase shift mask is installed): | 23°C |
| Humidity in exposure chamber (atmosphere in which phase shift mask is installed): | 43% |

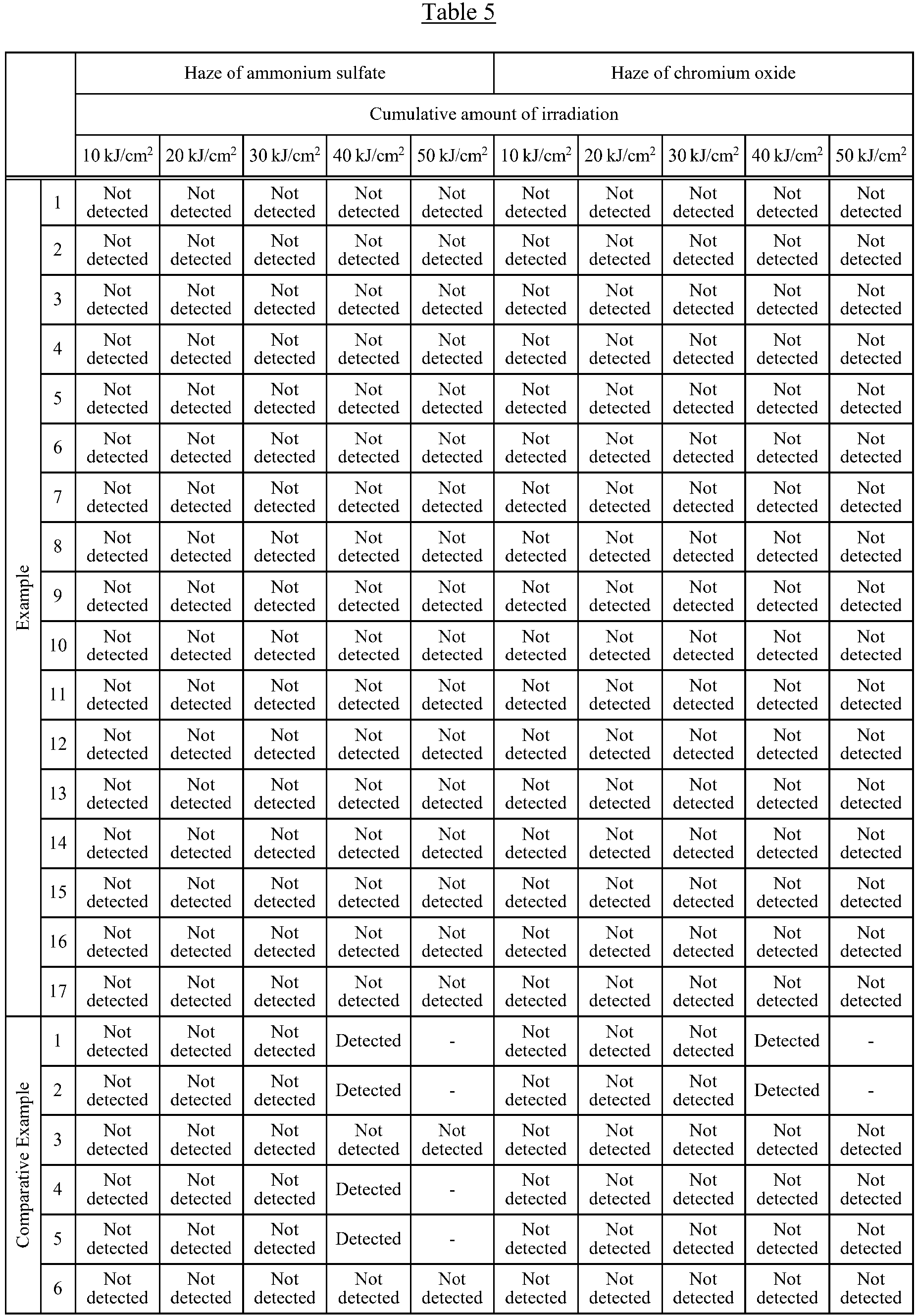

It was confirmed that an occurrence of a haze of chromium oxide was suppressed in a phase shift film pattern that was in contact with a layer free of carbon (C) of the light shielding film, and an occurrence of a haze of chromium oxide even when the phase shift film pattern contained molybdenum (Mo), as compared with a phase shift film pattern that was in contact with a layer containing carbon (C) of the light shielding film. In addition, it was confirmed that a haze of chromium oxide occurred in a phase shift film pattern containing molybdenum (Mo) in contact with a layer containing carbon (C) of the light shielding film. Furthermore, it was confirmed that an occurrence of a haze of ammonium sulfate ((NH₄)₂SO₄) was suppressed in a phase shift film (phase shift film pattern) in which a zeta potential satisfied a predetermined range (a zeta potential of -15 mV or more and +15 mV or less at a pH of 3 or more and 4 or less, and a zeta potential of -60 mV or more and +10 mV or less at a pH of 5 or more and 6 or less), as compared with a phase shift film (phase shift film pattern) in which a zeta potential did not satisfy the predetermined range.

## Claims

1. A phase shift mask blank comprising:
a transparent substrate;
a phase shift film provided on the transparent substrate, and formed of a material containing silicon (Si) and free of carbon (C); and
a light shielding film provided on a side of the phase shift film away from the transparent substrate, and formed of a material containing chromium (Cr), oxygen (O), nitrogen (N), and carbon (C),
wherein the light shielding film has a laminated structure including four layers: a first layer, a second layer, a third layer, and a fourth layer, or four layers: a first layer, a third layer, a second layer, and a fourth layer, in this order from the side away from the transparent substrate,
in the laminated structure, the first layer is a layer farthest from the transparent substrate, and the fourth layer is a layer in contact with the phase shift film,
the first layer contains chromium (Cr) and oxygen (O), with a chromium (Cr) content being 28 atom% or more and 40 atom% or less, and an oxygen (O) content being 47 atom% or more and 60 atom% or less, and the first layer has a thickness of 1 nm or more and 4 nm or less,
the second layer contains chromium (Cr), oxygen (O), nitrogen (N), and carbon (C), with a chromium (Cr) content being 30 atom% or more and 45 atom% or less, an oxygen (O) content being 28 atom% or more and 40 atom% or less, a nitrogen (N) content being 12 atom% or more and 24 atom% or less, and a carbon (C) content being 5 atom% or more and 15 atom% or less, and the second layer has a thickness of 18 nm or more and 24 nm or less,
the third layer contains chromium (Cr) and nitrogen (N), with a chromium (Cr) content being 50 atom% or more and 60 atom% or less, and a nitrogen (N) content being 20 atom% or more and 40 atom% or less, and the third layer has a thickness of 1 nm or more and 6 nm or less, and
the fourth layer contains chromium (Cr), oxygen (O), and nitrogen (N), and is free of carbon (C), with a chromium (Cr) content being 35 atom% or more and 44 atom% or less, an oxygen (O) content being 42 atom% or more and 54 atom% or less, and a nitrogen (N) content being 2 atom% or more and 20 atom% or less, and the fourth layer has a thickness of 18 nm or more and 36 nm or less.

2. The phase shift mask blank according to claim 1, wherein the phase shift film has a zeta potential of -15 mV or more and +15 mV or less at a pH of 3 or more and 4 or less, and a zeta potential of -60 mV or more and +10 mV or less at a pH of 5 or more and 6 or less.

3. The phase shift mask blank according to claim 1, wherein
the first layer contains nitrogen (N), with a nitrogen (N) content being 5 atom% or more and 25 atom% or less, and
the third layer contains oxygen (O), with an oxygen (O) content being 6 atom% or more and 30 atom% or less.

4. The phase shift mask blank according to claim 1, wherein the material forming the phase shift film contains nitrogen (N).

5. The phase shift mask blank according to claim 1, wherein the material forming the phase shift film is free of a transition metal.

6. The phase shift mask blank according to claim 1, wherein a total sheet resistance of the first layer, the second layer, the third layer, and the fourth layer of the light shielding film is 350 kΩ/□ or less.

7. The phase shift mask blank according to claim 1, wherein
the phase shift film has a phase difference of 175 degrees or more and 185 degrees or less and a transmittance of 6% or more and 30% or less with respect to exposure light that is ArF excimer laser (having a wavelength of 193 nm), and
the phase shift film has a thickness of 60 nm or more and 85 nm or less.

8. The phase shift mask blank according to claim 1, wherein a total optical density (OD) of the phase shift film and the light shielding film with respect to exposure light that is ArF excimer laser (having a wavelength of 193 nm) is 3 or more.

9. The phase shift mask blank according to claim 8, wherein the light shielding film has a thickness of 48 nm or more and 54 nm or less.

10. A method for manufacturing a phase shift mask having a circuit pattern of the phase shift film from the phase shift mask blank according to any one of claims 1 to 9, the method comprising:
(A) forming a first resist film on the light shielding film;
(B) forming a first resist pattern by patterning the first resist film;
(C) forming a light shielding film pattern by patterning the light shielding film by dry etching using a chlorine (Cl)-based gas containing oxygen (O), using the first resist pattern as an etching mask;
(D) forming a phase shift film pattern by patterning the phase shift film by dry etching using a fluorine (F)-based gas, using the light shielding film pattern as an etching mask;
(E) removing the first resist pattern;
(F) forming a second resist film on the light shielding film pattern;
(G) forming a second resist pattern on an outer peripheral edge portion located outside a region where the circuit pattern of the phase shift film is formed by patterning the second resist film;
(H) removing the light shielding film pattern in the region where the circuit pattern of the phase shift film is formed by dry etching using a chlorine (Cl)-based gas containing oxygen (O), using the second resist pattern as an etching mask; and
(I) removing the second resist pattern.
